(19) Europäisches Patentamt
European Patent Office
Office européen des brevets

(11) **EP 1 306 849 B1**

(12) **EUROPEAN PATENT SPECIFICATION**

(45) Date of publication and mention
of the grant of the patent:
**27.02.2008 Bulletin 2008/09**

(51) Int Cl.:
***G11C 7/10*** *(2006.01)*   ***G11C 5/00*** *(2006.01)*

(21) Application number: **02257252.3**

(22) Date of filing: **18.10.2002**

(54) **Devices and methods for controlling active termination resistors in a memory system**

Vorrichtung und Vefahren zum kontrollieren von aktiven Wiederstandsabschlüsse in einem Speichersystem

Dispositif et méthode pour contrôler des terminaisons de résistances actives dans un système de mémoire

(84) Designated Contracting States:
**DE GB IT**

(30) Priority: **19.10.2001 KR 2001064777**
**17.08.2002 KR 2002048708**
**21.08.2002 US 224632**

(43) Date of publication of application:
**02.05.2003 Bulletin 2003/18**

(73) Proprietor: **SAMSUNG ELECTRONICS CO., LTD.**
**Suwon-City, Kyungki-do (KR)**

(72) Inventor: **Kyung, Kye-hyun**
**Suwon-city,**
**Kyungki-do (KR)**

(74) Representative: **Mounteney, Simon James**
**Marks & Clerk**
**90 Long Acre**
**London WC2E 9RA (GB)**

(56) References cited:
**EP-A- 0 818 734**   **US-A- 4 748 426**
**US-A- 5 878 250**   **US-A- 6 130 854**

**EP 1 306 849 B1**

**Description**

BACKGROUND OF THE INVENTION

1. Field of the Invention

The present invention generally relates to memory circuits and systems, and more particularly, the present invention relates to devices and methods for controlling active termination resistors which are used to improve signaling characteristics in memory circuits and systems.

2. Description of the Related Art

Generally, as the bus frequency of a memory system (e.g., a memory system employing DRAM devices) increases, the signal integrity within the memory system degrades. Thus, a variety of bus topologies capable of reducing signal distortion have been developed. For example, it is known that the use of resistive terminations at either the receiver and/or transmitter sides within the memory system is an effective means for absorbing reflections and thereby improving signal performance. Resistive termination configurations of this type generally fall into one of two categories, i.e., passive termination or active termination.

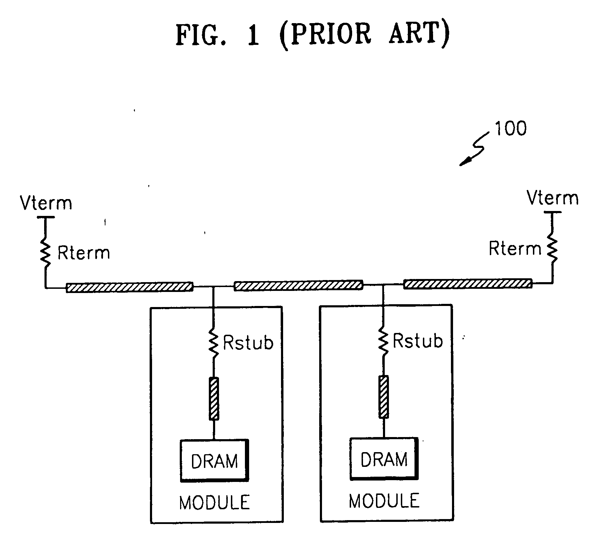

FIG. 1 shows an example of a passive resistive termination in a memory system. In particular, a so-called stub series terminated logic (SSTL) standard is illustrated in which the bus of a memory system 100 is connected to termination voltages Vterm through termination resistors Rterm, and DRAM-mounted memory modules are inserted into slots having predetermined stub resistors Rstub. In this case, the stub resistors Rstub are not mounted on the DRAM chips, and accordingly, the example here is one of an "off-chip" passive resistive termination.

When used in a double data rate (DDR) memory system, the passive resistive termination of the SSTL standard is capable of ensuring a data rate of about 300 Mbps. However, any increase in data rate beyond 300 Mbps tends to degrade signal integrity by increasing the load of the bus having the resistive stubs. In fact, a data rate of 400 Mbps or greater is generally not achievable with the SSTL bus configuration.

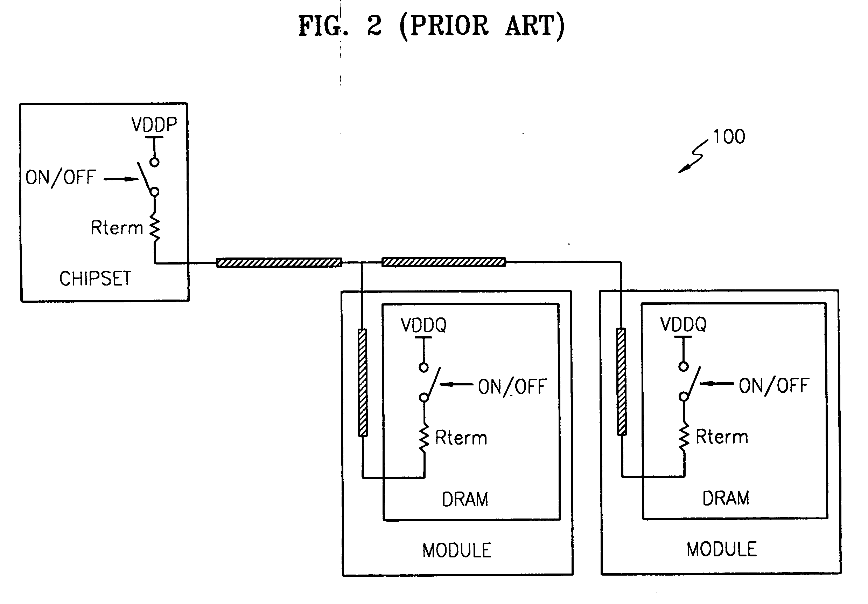

FIG. 2 shows an example of a memory system having an active resistive termination, and in particular, an active-termination stub bus configuration. Here, each chipset for controlling the operation of the memory modules, and DRAMs mounted on the respective modules, includes an active termination resistor Rterm. The active termination resistor Rterm is mounted "on-chip" and may be implemented by complementary metal oxide semiconductor (CMOS) devices. In this memory system, active bus termination is achieved through input/output (I/O) ports mounted on the modules.

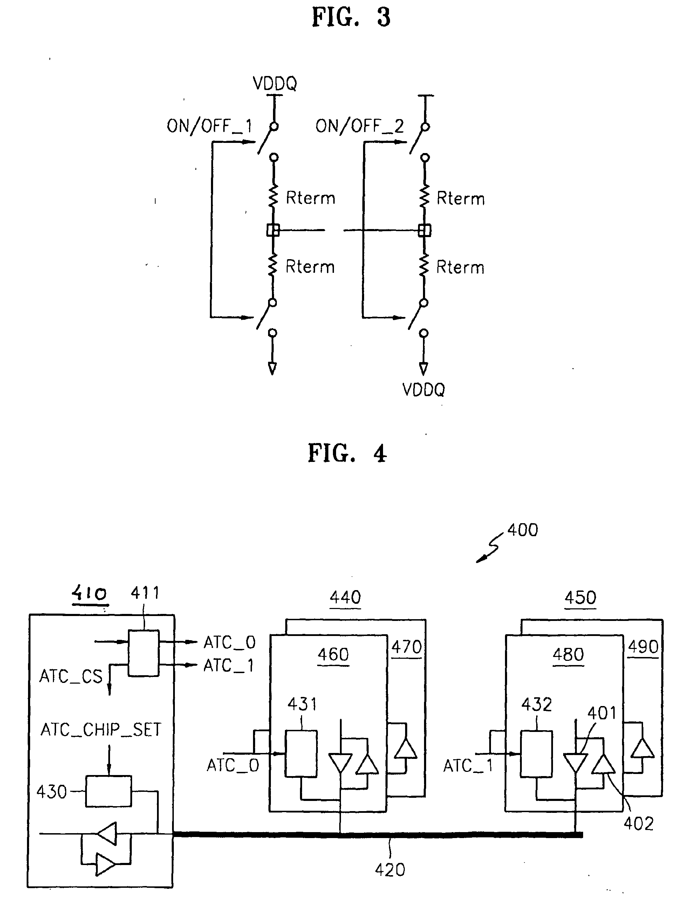

Each combination of one or more resistive elements Rterm and one or more ON/OFF switching devices in each DRAM is generally referred to herein as an "active terminator". Active terminators can take on any number of different configurations. FIG. 3 illustrates an example of an active terminator having a center-tapped termination which is described in U.S. Patent No. 4,748,426. In this example, the effective active termination resistance Rterm of the circuit can be varied between different values (e.g., 150 ohms and 75 ohms) depending on the enable/disable state of signals ON/OFF_ 1 and ON/OFF_2.

When a DRAM mounted in a memory module is not accessed (e.g., not read or written), the active termination resistor Rterm thereof is enabled by connecting the same to the bus to improve signal integrity. In contrast, when a DRAM is accessed (e.g., read or written), the active termination resistor Rterm thereof is disabled and disconnected from the bus to reduce load.

However, a considerable amount of time is required to enable the active termination resistors installed in the DRAM circuits in response to the active termination control signals, and when a module-interleaved write/read operation is performed, this time lapse can result in data bubbles, thereby degrading memory system performance.

DRAMs which include a delay locked loop (DLL) or phase locked loop (PLL) can overcome this problem by controlling the enabling/disabling of the active termination resistor thereof in synchronization with an external clock. However, in the case where the DLL or PLL is deactivated during a power down or standby mode of DRAMs of a corresponding memory module, enabling/disabling of the active termination resistor cannot be controlled.

US 5,878,250 describes circuitry that allows a register without an asynchronous loading capability to be asynchronously loaded. The circuitry includes a storage circuit and logic gates and is intended to be used in connection with programmable logic devices.

EP0818734 discloses a memory system which includes termination resistances and a switch unit for coupling a bus to termination voltage via the termination resistances in a first mode and for disconnecting the bus from the termination voltage in a second mode.

**2**

**EP 1 306 849 B1**

SUMMARY OF THE INVENTION

The present invention provides devices and methods for controlling an on/off state of active termination resistors mounted in a memory module irrespective of an operational mode of the DRAMs.

According to one aspect of the present invention, a memory system comprises a memory circuit in which an active termination circuit is mounted, the active termination circuit comprising a termination resistor which provides a termination resistance for the memory circuit, and a control circuit which receives an active termination control signal, and which selectively switches on and off the termination resistor in response to the active termination control signal. The control circuit includes a synchronous input buffer and an asynchronous input buffer which each receive the active termination control signal, and a switching circuit which selectively outputs an output of the synchronous input buffer or an output of the asynchronous input buffer according to an operational mode of the memory circuit. The output of the switching circuit controls an on/off state of the termination resistor.

Preferably the active termination circuit includes a mode register which stores data indicative of an operational mode of the memory circuit, and the control circuit receives an output of the mode register. The control circuit may include a switching circuit which selectively outputs an output of the synchronous input buffer or an output of the asynchronous input buffer according to the output of the mode register.

Preferably the memory system includes a bus line, a plurality of memory circuits coupled to the bus line, and a chip set, coupled to the bus line, which supplies a plurality of active termination control signals to the memory circuits. Each of the plurality of memory circuits may include a termination resistor and a control circuit. The control circuit may receive the active termination control signal supplied to the memory circuit thereof, and selectively switches on and off the termination resistor in response to the active termination control signal. Further, the control circuit may include a synchronous input buffer and an asynchronous input buffer which each receive the active termination control signal, and a switching circuit which selects one of an output of the synchronous input buffer or an output of the asynchronous input buffer according to an operational mode of the memory circuit containing the synchronous input buffer and the asynchronous input buffer. The output of the switching circuit may control an on and off state of the termination resistor.

Preferably each of the plurality of memory circuits includes a mode register which stores data indicative of an operational mode of the memory circuit and for each control circuit the switching circuit selects one of an output of the synchronous input buffer or an output of the asynchronous input buffer according to the data of the mode register.

According to another aspect of the present invention, a method for controlling an operation of a memory system includes applying an input signal to a synchronous input buffer and to an asynchronous input buffer of a memory circuit, and selectively outputting an output of the synchronous input buffer or an output of the asynchronous input buffer according to an operational mode of the memory circuit; and

enabling and disabling a termination resistance of the memory circuit according to the selected output of the synchronous input buffer or the asynchronous input buffer.

The controlling method may further include receiving an operational mode signal which is supplied externally of the memory circuit, wherein a value of the operational mode signal controls the selective outputting of the output of the synchronous input buffer or the output of the asynchronous input buffer.

The controlling method may further include receiving a value stored in a mode register of the memory circuit, wherein the value of the mode register controls the selective outputting of the output of the synchronous input buffer or the output of the asynchronous input buffer.

Preferably the method includes supplying an active termination control signal to both the synchronous input buffer and the asynchronous input buffer of the memory circuit, selecting an output of the synchronous input buffer when the memory circuit is in an active operational mode, and selecting an output of the asynchronous input buffer when the memory circuit is in a standby or power-down operational mode, and setting an on/off state of the termination resistor according to the selected one of the output of the synchronous input buffer or the output of the asynchronous input buffer thereby controlling the on/off state of the termination resistor.

Preferably the memory system has a plurality of memory modules connected to a data bus, and each of the memory modules is for mounting at least one of a plurality of memory circuits thereto, the plurality of memory circuits having a plurality of termination resistors. The method may include supplying an active termination control signal to both a synchronous input buffer and an asynchronous input buffer of each of the memory circuits of each of the memory modules, selecting, in each of the memory circuits, an output of the synchronous input buffer when the memory circuit is in an active operational mode, and selecting an output of the asynchronous input buffer when the memory circuit is in a standby or power-down operational mode, and setting, in each of the memory circuits, an on/off state of the termination resistor according to the selected one of the output of the synchronous input buffer or the output of the asynchronous input buffer, thereby controlling the plurality of termination resistors.

Preferably the memory system has at least a first memory module and a second memory module connected to a data bus, and each of the memory modules is for mounting at least one of the plurality of memory circuits thereto. The method may include transmitting, in response to a read/write instruction of the first memory module, an active termination control signal to each of the memory circuits of the second memory module, supplying the active termination control signal to both a synchronous input buffer and an asynchronous input buffer of each of the memory circuits of the second memory module, selecting, in each of the memory circuits of the second memory module, an output of the synchronous input buffer when the second memory module is in an active operational mode, and selecting an output of the asynchronous input buffer when the second memory module is in a standby or power-down operational mode, and setting, in each memory circuit of the second memory module, an on/off state of a termination resistor according to the selected one of the output of the synchronous input buffer or the output of the asynchronous input buffer, thereby controlling the plurality of termination resistors.

## BRIEF DESCRIPTION OF THE DRAWINGS

The above object and advantages of the present invention will become more apparent by describing in detail preferred embodiments thereof with reference to the attached drawings in which:

FIG. 1 shows a memory system having a conventional stub series terminated logic (SSTL) configuration;
FIG. 2 shows a memory system having a conventional active-termination stub bus configuration;
FIG. 3 illustrates an example of a conventional active terminator having a center-tapped termination;
FIG. 4 shows a memory system according to an embodiment of the present invention having an active-termination stub bus configuration;
FIG. 5A shows a first memory system according to the present invention in which dual in-line modules (DiMM) are mounted;
FIG. 5B is a table of control modes of the first memory system of FIG. 5A;
FIG. 5C shows a second memory system according to the present invention in which memory modules DiMMs are mounted;
FIG. 5D is a table of control modes of the second memory system of FIG. 5C;
FIG. 6 illustrates an active terminator control input-buffer according-to the present invention;
FIGS. 7A and 7B are timing diagrams of a synchronous active termination resistor control (ATC) mode during read and write operations, respectively;
FIG. 8 is a timing diagram of an asynchronous ATC mode;
FIGS. 9A through 9C are timing charts of an operation of the memory system when both modules DiMM0 and DiMM1 are in an active mode;
FIGS. 10A through 10C are timing charts of an operation of the memory system when the DiMM0 is in an active mode, and the DiMM1 is in a power down or standby mode;
FIG. 11 shows a memory system according to another embodiment of the present invention having an active-termination stub bus configuration;
FIGS. 12A through 12E are tables of the status of each DiMM and control modes of active terminators according to the present invention;
FIGS. 13 through 17 show memory systems according to the present invention in which different DiMMs are mounted;
FIG. 18 shows another embodiment of the memory system according to the present invention having an active-termination stub bus configuration;
FIG. 19 is a detailed circuit diagram of the termination resistor of FIG. 13;
FIG. 20 shows an example of a control signal generating circuit having a fuse; and
FIG. 21 shows another example of the control signal generating circuit having a fuse.

## DETAILED DESCRIPTION OF THE INVENTION

The following embodiments and accompanying drawings are provided so that advantages and features of the present invention will be thorough and complete, and will fully convey the concept of the invention to those skilled in the art. The present invention will be described more fully with reference to the accompanying drawings, in which preferred embodiments of the invention are shown. In the drawings, like reference numerals are used to refer to like elements throughout.

FIG. 4 shows a preferred embodiment of a memory system 400 according to an embodiment of the present invention in which an active-termination stub bus configuration is employed. Referring to FIG. 4, the-memory system 400 includes a chipset 410, a data bus 420, a first memory module 440 in which DRAMs 460 and 470 are mounted, and a second memory module 450 in which DRAMs 480 and 490 are mounted. The memory modules 440 and 450 may be mounted in card slots (not shown) of the memory system 400.

The first and second memory modules 440 and 450 may be implemented, for example, by a dual in-line memory module (DIMM) or single in-line memory module (SIMM). Further, while two DRAMs 460 (480) and 470 (490) are illustrated in FIG. 4 for each of the modules 440 and 450, additional DRAMs may be mounted in each of the first and second memory modules 440 and 450. Also, each of the chipset 410 and the DRAMs 460, 470, 480 and 490 are equipped with a driver 401 and an input buffers 402 for the writing and reading of data.

The chipset 410 includes an active terminator 430 which is enabled and disabled by an ATC_Chip_Set (ATC_CS) signal. In addition, each of the DRAMs 460 and 470 of the module 440 includes an active terminator 431 which is enabled and disabled by the ATC_0 signal, and each of the DRAMS 480 and 490 of the module 450 includes an active terminator 432 which is enabled and disabled by the ATC_1 signal. Further, the chipset 410 includes an ATC signal generator 411 which, as described herein below, generates a chipset control signal ATC_CS, a first control signal ATC_0, and a second control signal ATC_1 according to read/write modes of the memory modules 440 and 450.

Generally, when data is written to or read from the DRAMs 460 and 470, the chipset 410 outputs a data write/read command to the DRAMs 460 and 470 mounted in the first memory module 440. In addition, the chipset 410 outputs the first control signal ATC_0 to the DRAMs 460 and 470 for disabling the active terminator 431 of the DRAMs 460 and 470, and outputs the second control signal ATC_1 to the DRAMs 480 and 490 for enabling the active terminators 432 of the DRAMs 480 and 490.

In other words, the active terminators of a memory module which is being subjected to a data write or read operation are disabled, and the active terminators of the other memory module(s) in which data is neither written nor read are enabled. In addition, however, according to the present embodiment, the active terminator is selectively asynchronously or synchronously controlled according to an operational mode of each memory module. Herein, the phrase "operation mode" refers to, for example, active, power-down and standby modes of the memory module.

"Synchronous ATC mode" refers to a mode in which the active terminator of a DRAM is enabled or disabled in synchronization with the external clock signal CLK when the DLL or PLL of the DRAM is activated. In other words, the termination resistors of the DRAMs are enabled or disabled in synchronization with the external clock CLK in this control mode.

"Asynchronous ATC mode" refers to a mode in which the termination resistor of a DRAM is enabled or disabled asynchronously with the external clock signal CLK when the DLL or PLL of the DRAM is deactivated (in a power down (Pdn) mode or standby (Stby) mode). In other words, the termination resistors of the DRAMs are enabled or disabled asynchronously with the external clock CLK in this control mode.

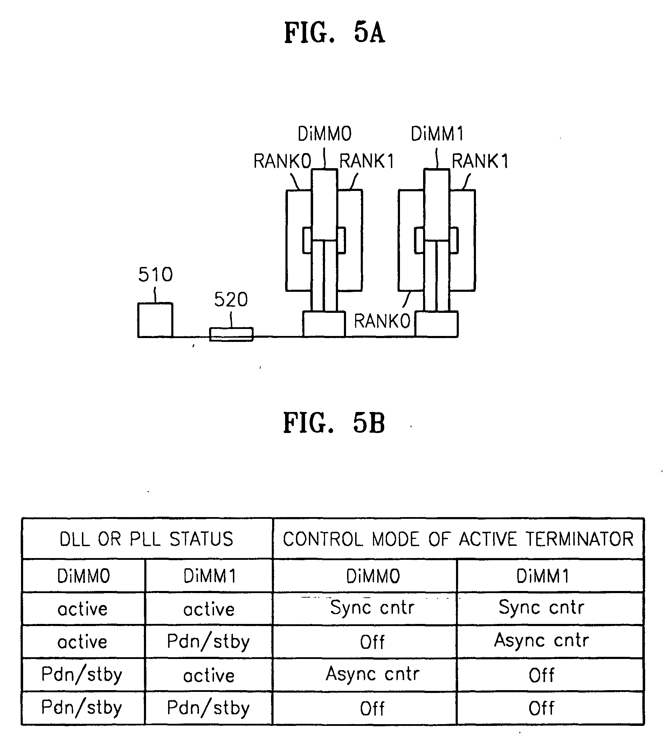

For example, referring to FIG. 5A, DiMM0 and DiMM1 denote first and second dual in-line memory modules, respectively. Each module is equipped with DRAMs (rank 0 and rank 1) as shown, and is connected to a chipset 510 by way of a data bus 520. In addition, each of the DRAMs includes a synchronization circuit, for example, a delay locked loop (DLL) or phase locked loop (PLL), for generating an internal clock in synchronization with an external clock CLK. A detailed description of operation of the DLL and PLL is omitted here since these circuits are well known to those skilled in the art.

FIG. 5B is a table of the status of the DLL or PLL described above and control modes of the active terminator. As shown in FIG. 5B, the active terminator of a module is asynchronously controlled when each of the memory modules DiMM0 and DiMM1 is in a power down or standby mode, and the active terminator of a module is synchronously controlled when each of the memory modules DiMM0 and DiMM1 is in an active mode. Whether a module is in an active mode, standby mode, or power down mode, may be determined from the status of the DLL or PLL of the memory module.

As such, when both memory modules DiMM0 and DiMM1 are in an active state, the active terminator of both modules is synchronously controlled. When one of the modules is in a power down or standby mode (Pdn/stby) while the other is in an active mode, the active terminator of the one module is asynchronously controlled. In this manner, the enabling/disabling of the active terminator can be controlled in the case where the DLL or PLL is deactivated during a power down or standby mode of a corresponding memory module. Accordingly, it not necessary to first activate the DLL or PLL prior to initiating control of the active terminator.

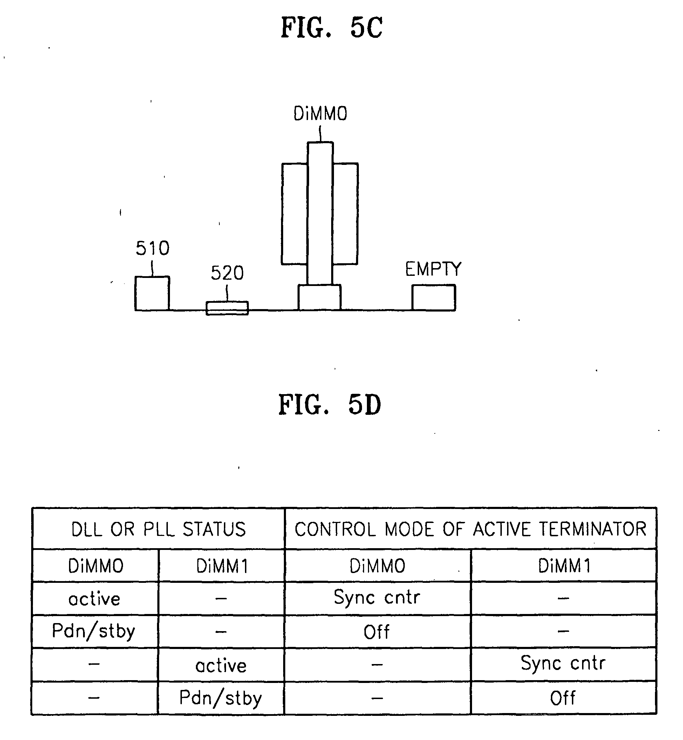

FIG. 5C illustrates the case where the module DiMM1 of the memory system is empty, and FIG. 5D is a table of the status of the DLL or PLL and control modes of the active terminator in the case where either one of the DiMM0 or DiMM1 modules is empty.

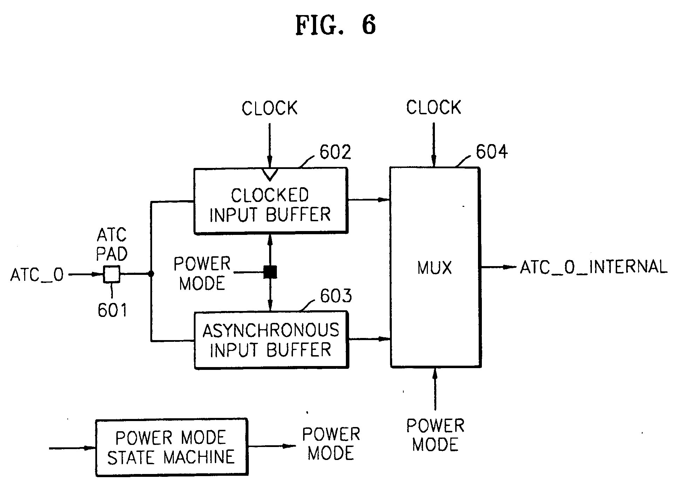

Referring now to FIG. 6, a functional diagram of a synchronous and asynchronous active terminator control (ATC) input buffer of the present invention is shown. An ATC pad 601 receives a first control signal ATC_0 from the chipset 410 (FIG. 4). The first control signal ATC_0 is applied in parallel to a clocked (synchronous) input buffer 602 and an asynchronous input buffer 603. A multiplexer (MUX) 604 effectively selects one of an output of the synchronous input buffer 602 or an output of the asynchronous input buffer 603 according to an operational mode signal applied thereto.

In addition, the operational mode signal, which is supplied from an operational mode state machine of the memory system, is also used to operatively enable/disable the buffers 602 and 603. The ATC input buffer of FIG. 6 operates as described above with reference to FIGS. 5B and 5D to selectively control the active terminators of the memory modules in either a synchronous or asynchronous mode.

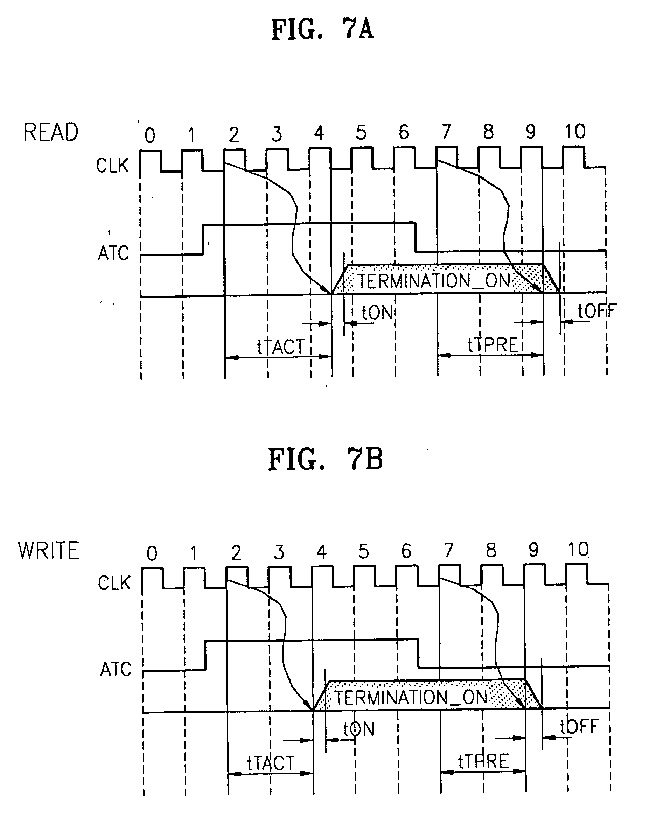

ATC control in a synchronous mode for each of a read and write operation is illustrated in the timing charts of FIGS. 7A and 7B, respectively. It is assumed here that data is written with reference to a clock center, data is read with reference to a clock edge, and that the DRAMs operate at a double data rate with a burst length of 8.

The active terminators of the DRAMs are enabled preferably within a second time period tON following a first time period tTACT counted from the activation of the control signal ATC output from the chipset 410. The active terminators of the DRAMs are disabled preferably within a fourth time period tOFF following a third time period tTPRE counted from the deactivation of the control signal ATC. The first time period tTACT and the third time period tTPRE are set as an absolute time length which is not based on the external clock signal CLK.

Referring first to the read operation of FIG. 7A, the ATC is responsive at the rising edge of CLK 2 to a "high" state of the ATC signal to enable the active terminator after a delay period tTACT. In this case, the enabling of the active terminator is -synchronized with the falling edge of CLK 4 as shown, and the active terminator is considered to be "on" after a further delay time tON.

Then, the ATC is responsive at the rising edge of CLK 7 to a "low" state of the ATC signal to disable the active terminator after a delay period tTPRE. Again, the disabling of the active terminator is synchronized with the falling edge of CLK 9 as shown, and the active terminator is considered to be "off" after a further delay time tOFF. In this example, the following relationships may be established:

$$2.5tCC - 500ps < tTACT, tTPRE < 2.5tCC + 500ps$$

where tCC is a clock cycle time. Also, the time period tON and/or the time period tOFF may be set to be less than 2.5*tCC-500 ps.

Referring now to the write operation of FIG. 7B, the ATC is responsive at the rising edge of CLK 2 to a "high" state of the ATC signal to enable the active terminator after a delay period tTACT. In this case, the enabling of the active terminator is synchronized with the rising edge of CLK 4 as shown, and the active terminator is considered to be "on" after a further delay time tON. Then, the ATC is responsive at the rising edge of CLK 7 to a "low" state of the ATC signal to disable the active terminator after a delay period tTPRE. Again, the disabling of the active terminator is synchronized with the rising edge of CLK 9 as shown, and the active terminator is considered to be "off" after a further delay time tOFF. In this example, the following relationships may be established:

$$2.0tCC - 500ps < tTACT, tTPRE < 2.0tCC + 500ps$$

where tCC is a clock cycle time. Also, the time period tON and/or the time period tOFF may be set to be less than 0.5*tCC-500 ps.

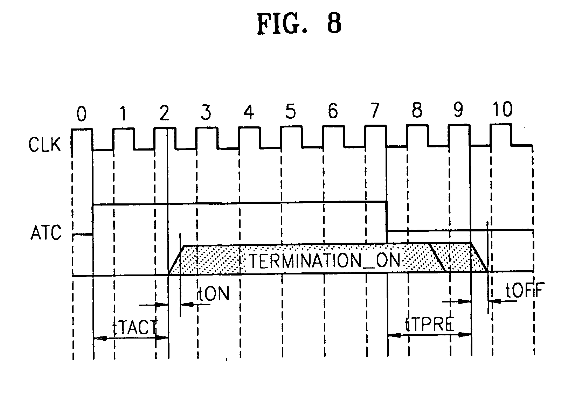

ATC control in an asynchronous mode is illustrated in the timing chart of FIG. 8. Here, the ATC is responsive to a "high" state of the ATC signal to enable the active terminator after a delay period tTACT. Note here that the enabling of the active terminator is not synchronized with the clock signal, but is instead determined by the amount of the delay tTACT. As before, the active terminator is considered to be "on" after a further delay time tON.

The ATC is then responsive to a "low" state of the ATC signal to disable the active terminator after a delay period tTPRE. Again, the disabling of the active terminator is not synchronized with the clock signal, but is instead determined by the amount of the delay tTPRE, and the active terminator is considered to be "off" after a further delay time tOFF. Here, for example, tTACT and tTPRE may be set between 2.5ns and 5.0ns. Also, the time period tON and/or the time period tOFF may be set to be less than 0.5*tCC-500 ps.

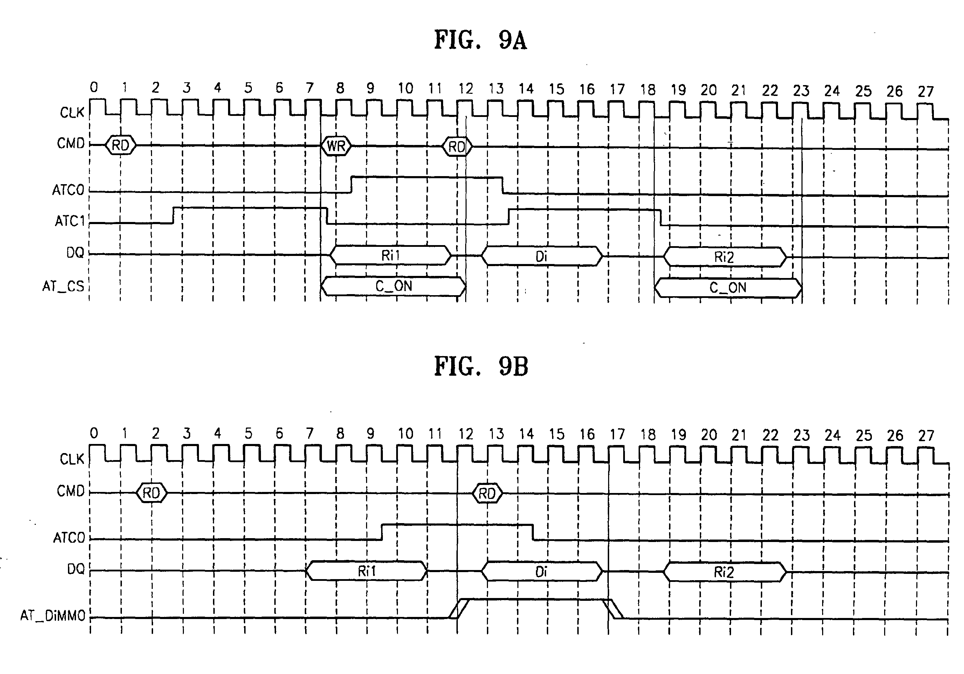

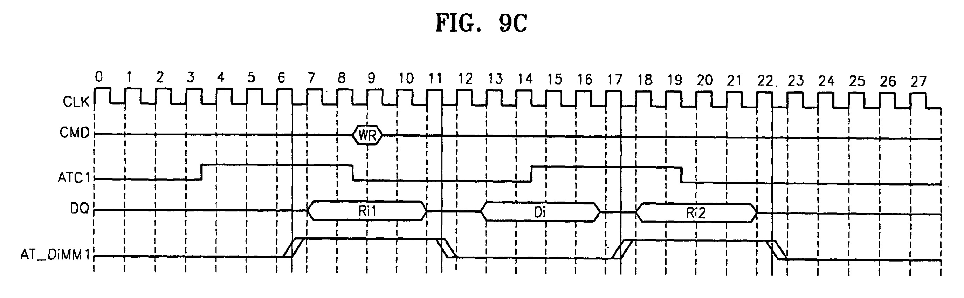

FIGS. 9A through 9C are timing charts of an operation of the memory system when both memory modules DiMM0 and DiMM1 are in an active mode. Since both modules are active, as shown in FIG. 5B, the ATC of each is carried out in a synchronous mode. FIG. 9A illustrates the operation of the chipset, FIG. 9B illustrates the operation of the first memory module DiMM0, and FIG. 9C illustrates the operation of the second memory module DiMM1. As shown, the chipset issues a sequence of commands including a read command RD to the DiMM0, a write command WR to the DiMM1, and another read command RD to the DiMM0.

To read the first memory module DiMM0, the active terminator of the second memory module DiMM1 must be enabled. Accordingly, the chipset outputs the read command RD to the first memory module DiMM0 and outputs the second control signal ACT1 to the second memory module DiMM1. The second memory module DiMM1 is responsive to the second control signal ATC1 to temporarily enable the active terminator thereof as shown by the active terminator AT_DiMM1 of FIG. 9C. Also, during the period in which the active terminator of the second module DiMM1 is enabled, data Ri1 is read from the first memory module DiMM0.

Likewise, to next write the second memory module DiMM1, the active terminator of the first memory module DiMM0 must be enabled. Accordingly, the write command WR is input to the second memory module DiMM1, and the first control signal ACT0 output from the chipset is input to the first memory module DiMM0. The first memory module DiMM0 is responsive to the first control signal ATC0 to temporarily enable the active terminator thereof as shown by the active terminator AT_DiMM0 of FIG. 9B. Also, during the period in which the active terminator of the first memory module DiMM0 is enabled, data Di is written to the second memory module DiMM1.

The second read operation of the first memory module DiMM0 is carried out in the same manner as the first read operation, with the second memory module DiMM1 being responsive to the second control signal ACT1 to enable the active terminator AT_DiMM1 of FIG. 9C.

Note also in FIG. 9A that the active terminator AT_CS of the chip-set is enabled only during the memory read operations. Active termination is not necessary in a write operation in the case where there is impedance matching of drivers.

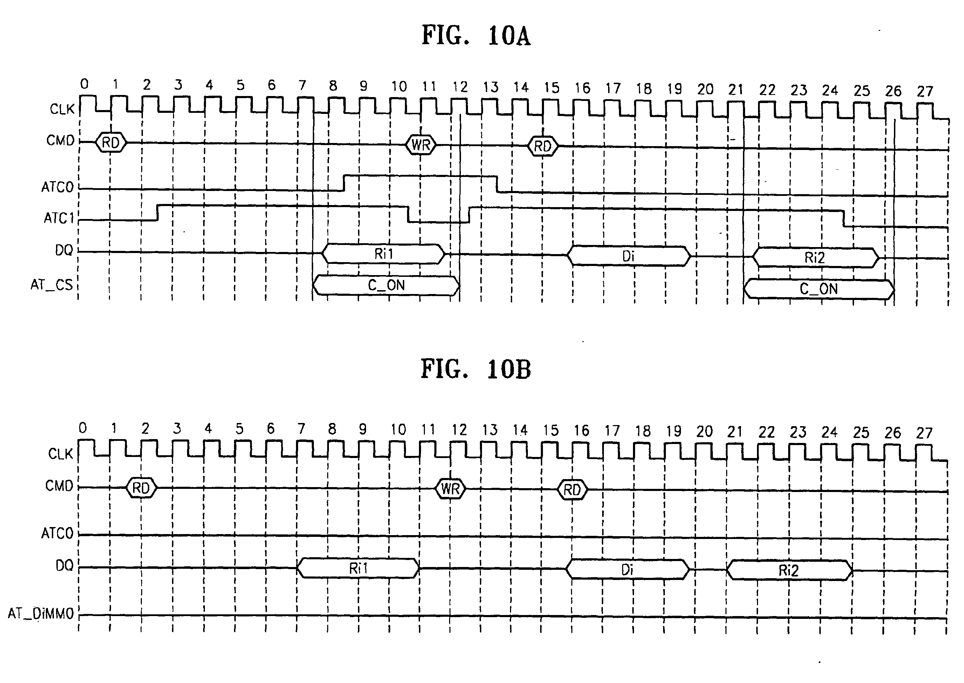

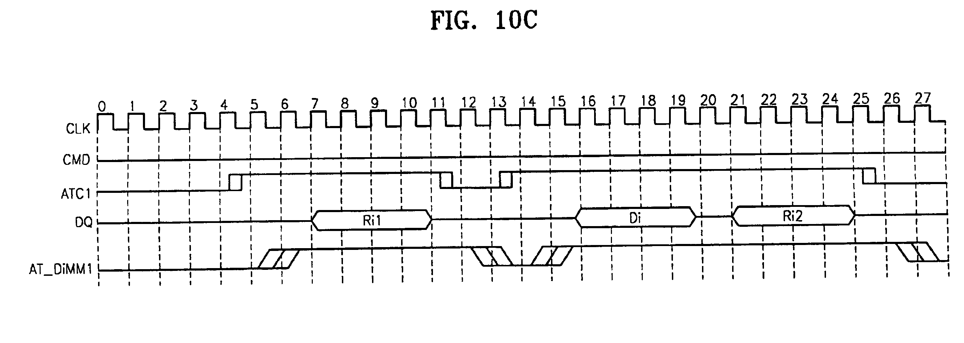

FIGS. 10A through 10C are timing charts of an operation of the memory system when the first memory module DiMM0 is in an active mode, and the second memory module DiMM1 is in a power down or standby mode. In this case, as shown in FIG. 5B, the ATC of the first memory module DiMM0 is off, and ATC of the second memory module DiMM1 is carried out in an asynchronous mode. FIG. 10A illustrates the operation of the chipset, FIG. 10B illustrates the operation of the first memory module DiMM0, and FIG. 10C illustrates the operation of the second memory module DiMM1. As shown, the chipset issues a sequence of commands to the active first memory module DiMM0, including a read command RD to the DiMM0, a write command WR to the DiMM0, and another read command RD to the DiMM0.

To read the first memory module DiMM0, the active terminator of the second memory module DiMM1 must be enabled. Accordingly, the first read command RD output from the chipset is input to the first memory module DiMM0, and the second control signal ATC1 output from the chipset is input to the second memory module DiMM1. As shown, the second memory module DiMM1 is asynchronously responsive to the second control signal ATC1 to temporarily enable the active terminator thereof as shown by the active terminator AT_DiMM1 of FIG. 10C. Also, during the period in which the active terminator of the second memory module DiMM1 is enabled, data Ri1 is read from the first memory module DiMM0.

Likewise, to next write the first memory module DiMM0, the active terminator of the second memory module DiMM1 must be enabled. Accordingly, the write command WR output from the chipset is input to the first memory module DiMM0, and the second control signal ACT1 is input to the second memory module DiMM1. The first memory module DiMM0 is again asynchronously responsive to the second control signal ATC to enable the active terminator thereof as shown by the active terminator AT_DiMM1 of FIG, 10C. At this time, data Di is written to the first memory module DiMM0.

In the example of FIGS. 10A through 10C, the second read command RD follows closely after the write command WR. As such, the second control signal ACT1 remains high, and the active terminator of the second memory module DiMM1 remains enabled throughout the second read operation. Note also, as is apparent from FIG. 10C, the disabling of the active terminator of the second memory module DiMM1 is asynchronous as well.

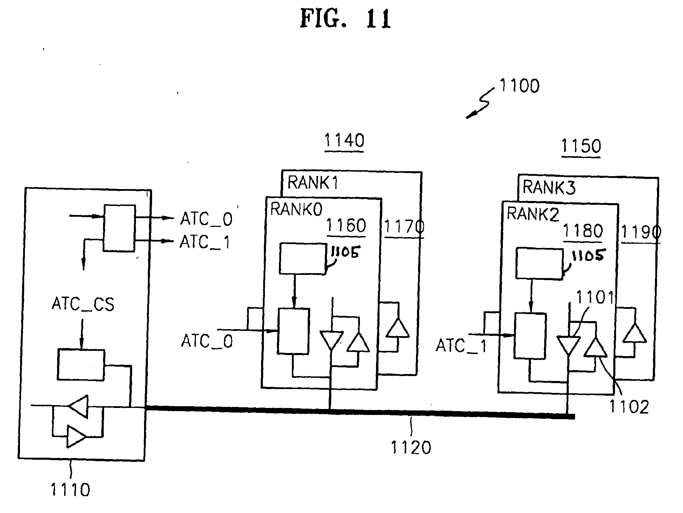

A second embodiment of the present invention will now be described with initial reference to FIG. 11 of the drawings. In this embodiment, DRAM chips positioned on each side of each DiMM module are individually ATC controlled by the combination of common ATC signaling and mode registers. In particular, as shown in FIG. 11, the memory system 1100 includes a chipset 1110, a data bus 1120, a first memory module 1140 in which DRAMs 1160 and 1170 are mounted, and a second memory module 1150 in which DRAMs 1180 and 1190 are mounted. The memory modules 1140 and 1150 may be mounted in card slots (not shown) of the memory system 1100.

The first and second memory modules 1140 and 1150 may be implemented, for example, by a dual in-line memory module (DiMM). Further, while two DRAMs 1160 (1180) and 1170 (1190) are illustrated in FIG. 11 for each of the modules 1140 and 1150, additional DRAMs may be mounted in each of the first and second memory modules 1140 and 1150. Also, each of the chipset 1110 and the DRAMs 1160, 1170, 1180 and 1190 are equipped with a driver 1101 and an input buffer 1102 for the writing and reading of data.

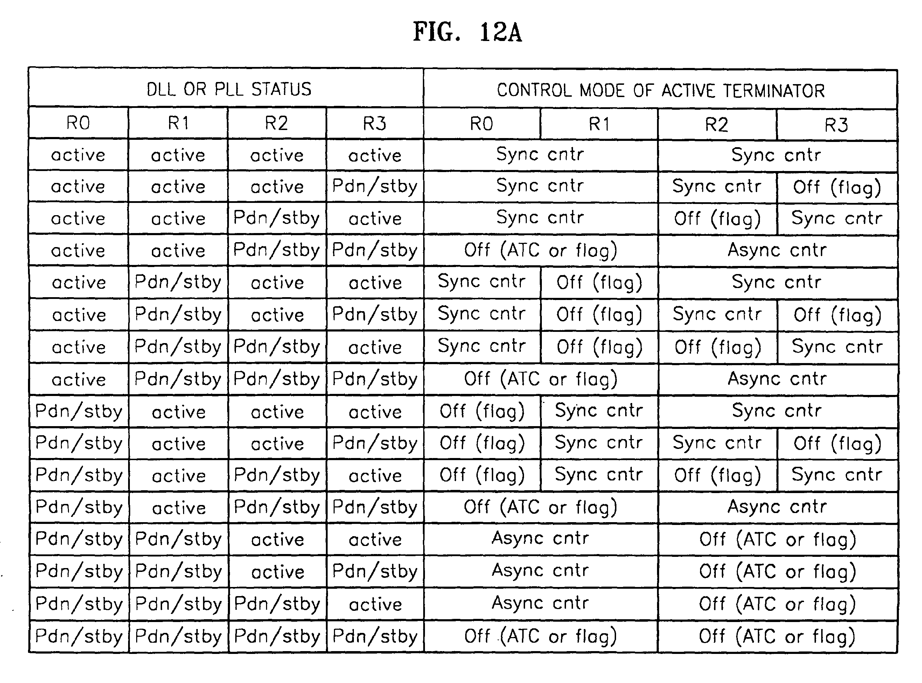

In contrast to the first embodiment, the DRAMs 1160, 1170, 1180 and 1190 are additionally equipped with a mode register 1105 which includes data indicative of the operational mode (active, power down, standby) of a corresponding DRAM. In a manner described below with reference to FIGS. 12A through 12E, the output of each register controls the operation of the MUX 604 of each ATC control circuit shown in FIG. 6 to thereby select a synchronous or asynchronous control mode.

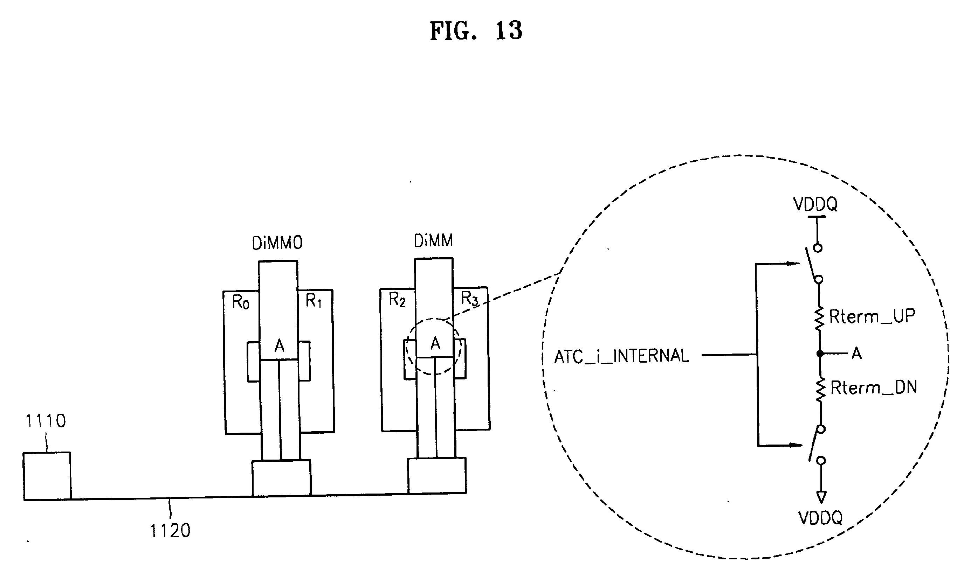

In particular, FIG. 13 illustrates a "2r/2r" configuration in which each of the first and second memory modules DiMM0 and DiMM1 are equipped with two DRAM circuits. In this case, the active terminator control (ATC) of the memory system is carried out as shown below in FIG. 12A. Here, Rank 0 (R0) designates DRAM 1160, Rank 1 (R1) designates DRAM 1170, Rank 2 (R2) designates DRAM 1180, and Rank 3 (R3) designates DRAM 1190.

In FIG. 12A, "Off(flag)" means that the termination resistors are disabled exclusively by the setting of the flag, and "Off(ATC or flag)" means that the termination resistors are disabled selectively by the user's setting of the control signal or the flag.

When the mode registers indicate that all ranks are active, both the first and second memory modules DiMM0 and the DiMM1 are operated in a synchronous ATC mode. On the other hand, for example, when R3 is in a pdn/stby mode, ATC ofR3 is turned off (or flagged) and the remaining ranks R0 through R2 are operated in a synchronous ATC mode. Further, when both R2 and R3 are in a pdn/stby mode, then ATC of the first memory module DiMM0 is turned off, and the ranks R2 and R3 of the second memory module DiMM1 are operated in an asynchronous ATC mode.

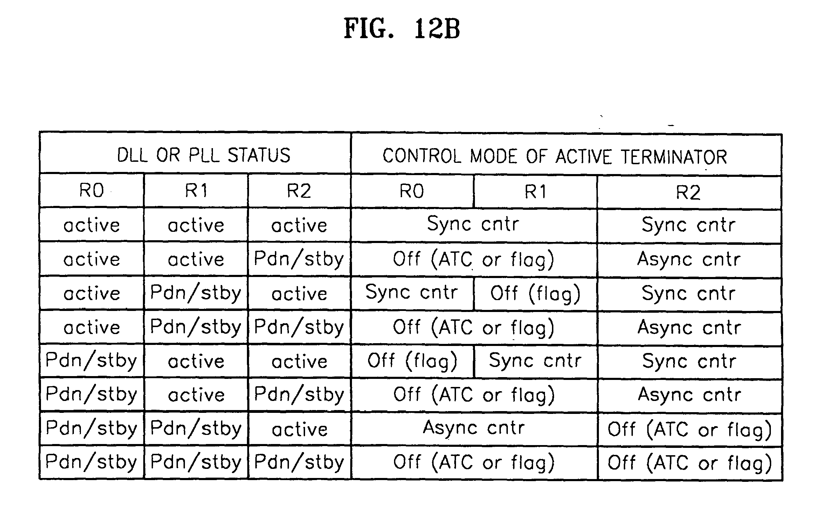

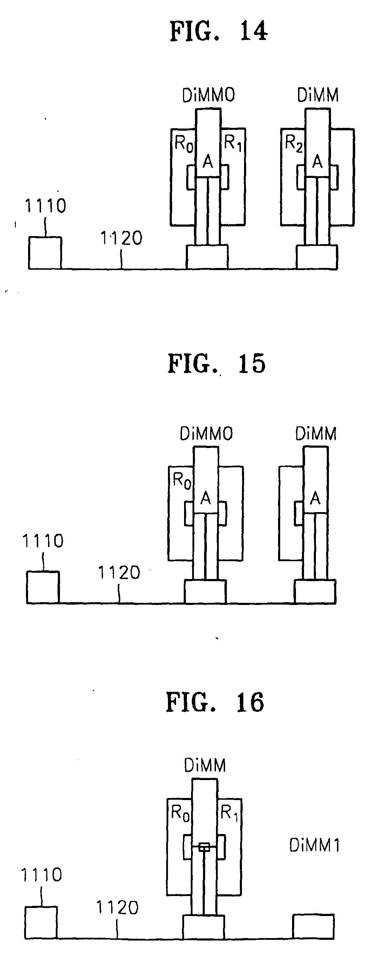

FIG. 14 illustrates a "2r/1r" configuration in which the first memory module DiMM0 is equipped with two DRAM circuits, and the second memory module DiMM1 is equipped with one DRAM circuit. In this case, the active terminator control (ATC) of the memory system is carried out as shown in FIG. 12B. Here, Rank 0 (R0) designates DRAM 1160, Rank 1 (R1) designates DRAM 1170, and Rank 2 (R2) designates DRAM 1180.

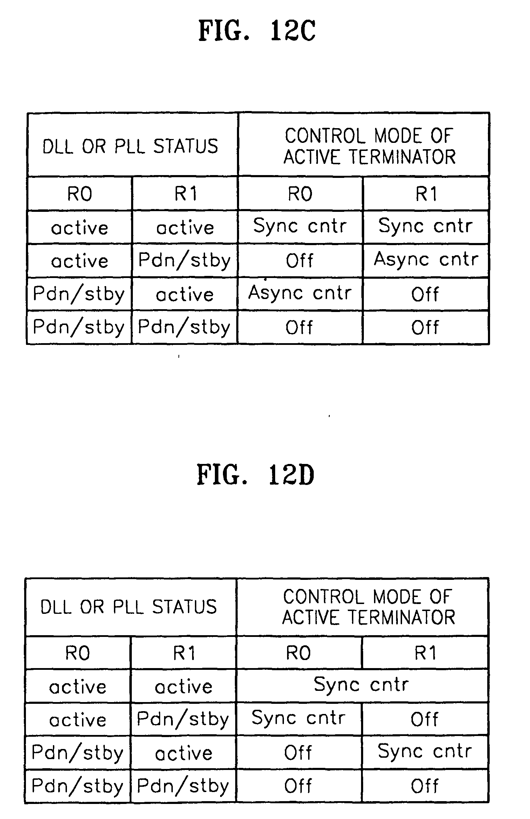

FIG. 15 illustrates a "1r/1r" configuration in which the first memory module DiMM0 is equipped with one DRAM circuit, and the second memory module DiMM1 is equipped with one DRAM circuit. In this case, the active terminator control (ATC) of the memory system is carried out as shown in FIG. 12C. Here, Rank 0 (R0) designates DRAM 1160 of the first memory module DiMM0, and Rank 1 (R1) designates DRAM 1180 of the second memory module DiMM1.

FIG. 16 illustrates a "2r/empty" configuration in which the first memory module DiMM0 is equipped with two DRAM circuits, and the second memory module DiMM1 is equipped with no DRAM circuits. In this case, the active terminator control (ATC) of the memory system is carried out as shown in FIG. 12D. Here, Rank 0 (R0) designates DRAM 1160 of the first memory module DiMM0, and Rank 1 (R1) designates DRAM 1170 of the first memory module DiMM0.

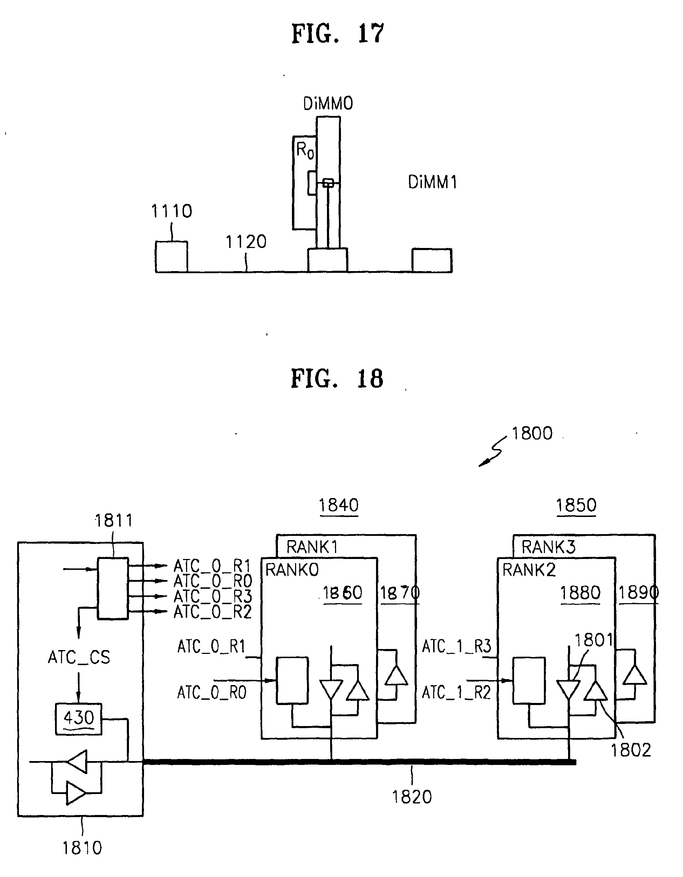

FIG. 17 illustrates a "1 r/empty" configuration in which the first memory module DiMM0 is equipped with one DRAM circuit, and the second memory module DiMM1 is equipped with no DRAM circuits. In this case, the active terminator control (ATC) of the memory system is carried out such that when R0 is active, synchronous ATC is carried out, and when R0 is in Pdn/sdby mode, ATC is off. Here, Rank 0 (R0) designates the DRAM 1160 of the first memory module DiMM0.

A third embodiment of the present invention will now be described with reference to FIG. 18 of the drawings. In this embodiment, DRAM chips 1860 (1880) and 1870 (1890) positioned on each side of each of the memory modules DiMM are individually ATC controlled by individual ATC signals issued from the chipset. In particular, as shown in FIG. 18, the memory system 1800 includes a chipset 1810, a data bus 1820, a first memory module 1840 in which DRAMs 1860 and 1870 are mounted, and a second memory module 1850 in which DRAMs 1880 and 1890 are mounted. The memory modules 1840 and 1850 may be mounted in card slots (not shown) of the memory system 1800.

The first and second memory modules 1840 and 1850 may be implemented, for example, by a dual in-line memory module (DiMM). Further, while two DRAMs 1860 (1880) and 1870 (1890) are illustrated in FIG. 18 for each of the modules 1840 and 1850, additional DRAMs may be mounted in each of the first and second memory modules 1840 and 1850. Also, each of the chipset 1810 and the DRAMs 1860, 1870, 1880 and 1890 are equipped with a driver 1801 and an input buffer 1802 for the writing and reading of data.

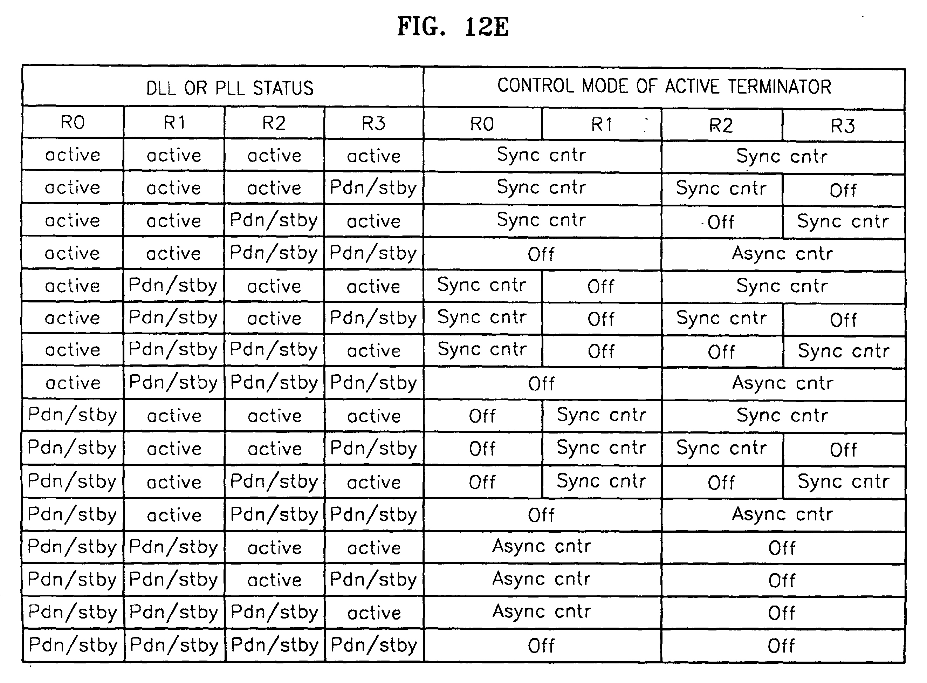

In contrast to the first and second embodiments, the ATC signal generator 1811 of the present embodiment shown in FIG. 18 supplies individual ATC signals ATC_0_R0 and ATC_0_R1 to the DRAMs 1860 and 1870 of the first memory module 1840 (DiMM0), and further supplies individual ATC signals ATC_1_R2 and ATC_1_R3 to the DRAMs 1880 and 1890 of the second memory module 1850 (DiMM1). In a manner described in FIG. 12E, the operation of the MUX 604 of each ATC control circuit shown in FIG. 6 it controlled to thereby select a synchronous or asynchronous control mode on the basis of the operational states of each individual DRAM (or rank).

In particular, FIG. 12E corresponds to the "2r/2r" configuration of FIG. 13 in which each of the first and second memory modules DiMM0 and DiMM1 are equipped with two DRAM circuits. Here, Rank 0 (R0) designates DRAM 1860, Rank 1 (R1) designates DRAM 1870, Rank 2 (R2) designates DRAM 1880, and Rank 3 (R3) designates DRAM 1890.

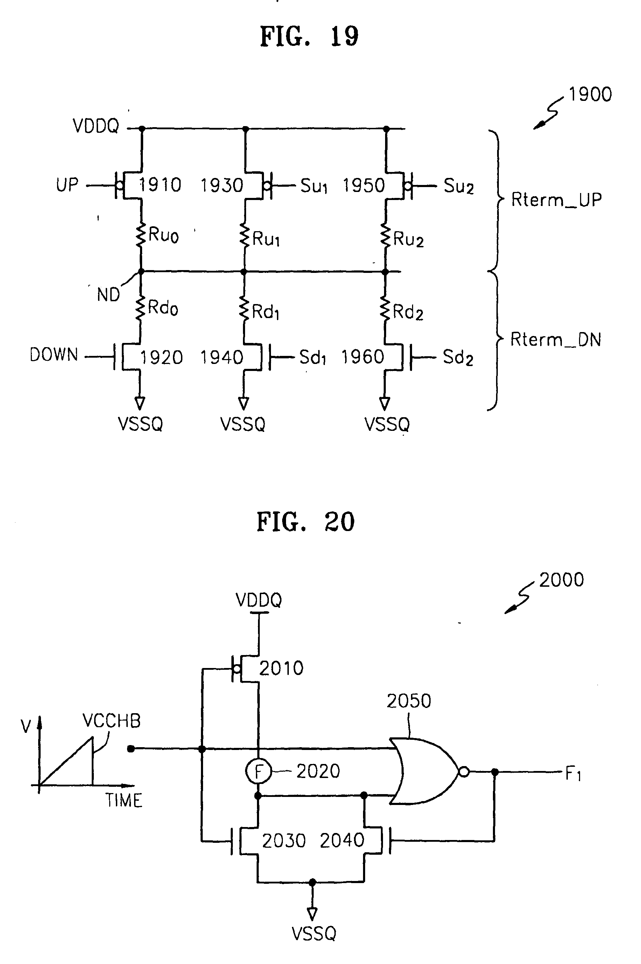

FIG. 19 is a detailed circuit diagram of termination resistors Rtem_UP and Rterm_DN shown in FIG. 13. Referring to FIG. 19, a first UP resistor $Ru_0$ is coupled to a power voltage VDDQ via a PMOS transistor 1910 and to a node ND. A second UP resistor $Ru_1$ is coupled to the power voltage VDDQ via a PMOS transistor 1930 and to the node ND, and a third UP resistor $Ru_2$ is coupled to the power voltage VDDQ via a PMOS transistor 1950 and to the node ND.

The PMOS transistors 1910, 1930, and 1950 are turned on or off in response to control signals UP, $SU_1$ and $SU_2$, respectively.

Preferably, a DRAM is designed such that the resistance of each of the first, second, and third UP resistors $Ru_0$, $Ru_1$, and $Ru_2$ is set as follows. The resistance of the first UP resistor $Ru_0$ is set to be slightly greater than a predetermined target value. The resistance of the second UP resistor $Ru_1$ is set to the predetermined target value when connected in parallel to the first UP resistor $Ru_0$. The resistance of the third UP resistor $Ru_2$ is set to be slightly lower than the predetermined target value when connected in parallel to the first UP resistor $Ru_0$ and the second UP resistor $Ru_1$. Accordingly, the resistance of the termination resistor Rterm_UP is determined by the combination of the first, second, and third UP resistors $Ru_0$, $Ru_1$, and $Ru_2$.

The first DOWN resistor $Rd_0$ is coupled to the node ND and to a ground voltage VSSQ via an NMOS transistor 1920, the second DOWN resistor $Rd_1$ is coupled to the node ND and to the ground voltage VSSQ via an NMOS transistor 1940, and the third DOWN resistor $Rd_2$ is coupled to the node ND and to the ground voltage VSSQ via an NNOS transistor 1960.

The NMOS transistors 1920, 1940, and 1960 are turned on or off in response to control signals DOWN, $SD_1$ and $SD_2$, respectively.

It is preferable that the MOS transistor 1930 and 1940 are turned on and the MOS transistors 1950 and 1960 are turned off in a default situation. Alternatively, the MOS transistor 1930 and 1940 may be turned off and the MOS transistors 1950 and 1960 are turned on in a default situation.

Preferably, a DRAM is designed such that the resistance of each of the first, second, and third DOWN resistors $Rd_0$, $Rd_1$, and $Rd_2$ is set as follows. The resistance of the first DOWN resistor $Rd_0$ is set to be slightly greater than a predetermined target value. The resistance of the second DOWN resistor $Rd_1$ is set to the-predetermined target value when connected in parallel to the first DOWN resistor $Rd_0$. The resistance of the third DOWN resistor $Rd_2$ is set to be slightly lower than the predetermined target value when connected in parallel to the first DOWN resistor $Rd_0$ and the second DOWN resistor $Ru_2$. Accordingly, the resistance of the termination resistor Rterm_DN is determined by the combination of the first, second, and third DOWN resistors $Rd_0$, $Rd_1$, and $Rd_2$.

FIG. 20 shows an example of a control signal generating circuit having a fuse. Referring to FIG. 20, a control signal generating circuit 2000 includes a plurality of transistors 2010, 2030, and 2040, a fuse 2020, and a logic gate 2050.

The PMOS transistor 2010 is coupled between a power voltage VDDQ and one end of the fuse 2020. A power-up signal VCCHB is input to a gate of the PMOS transistor 2010. The NMOS transistor 2030 is connected between the other end of the fuse 2020 and a ground voltage VSSQ. The power-up signal VCCHB is input to a gate of the NMOS transistor 2030. As shown in FIG. 20, the level of the power-up signal VCCHB increases for a predetermined time period and then drops and is maintained at a low level.

The fuse 2020 is connected between a drain of the PMOS transistor 1020 and a drain of the NMOS transistor 2030. The fuse 2020 can be cut by a variety of methods, for example, using a laser. The fuse 2020 may be implemented with a make-link or an anti-fuse.

The logic gate 2050 receives the power-up signal VCCHB and a signal from the drain of the NMOS transistor 2030, performs an NOR operation, and outputs the result $F_1$.

The NMOS transistor 2040 is connected between the drain of the NMOS transistor 2030 and the ground voltage VSSQ and has a gate connected to an output of the logic gate 2050.

Referring to FIG. 20, after a predetermined time period from when the fuse 2020 is cut and the power-up signal VCCHB is applied, the output signal $F_1$ of the logic gate 2050 is in a logic high. In contrast, after a predetermined time period from when the fuse 2020 is not cut and the power-up signal VCCHVB is applied, the output signal $F_1$ of the logic gate 2050 is in a logic low.

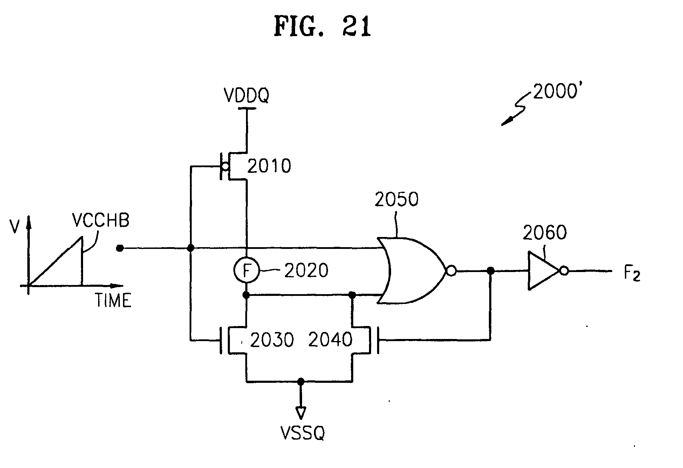

FIG. 21 shows another example of the control signal generating circuit having a fuse. Referring to FIG. 21, a control signal generating circuit 2000' further comprises an inverter 2060 at an output terminal of the control signal generating circuit 2000 of FIG. 20. When the fuse 2020 of the control signal generating circuit 2000' is not cut, an output signal $F_2$ of the inverter 2060 is in a logic high. When the fuse 3030 of the control signal generating circuit 2000' is cut, the output signal $F_2$ of the inverter 2060 is in a logic low.

Tuning the resistance of the termination resistors Rterm_UP and Rterm_DN to a predetermined target value will be described in detail with reference to FIGS. 19 and 21. When all resistors $Ru_0$, $Ru_1$, $Ru_2$, $Rd_0$, $Rd_1$, and $Rd_2$ are mounted in a semiconductor chip, the resistance of the first UP resistor $Ru_0$ and the resistance of the first DOWN resistor $Rd_0$ are measured in a test mode by using a tester.

Here, the resistance of the first UP resistor $Ru_0$ may be different from that of the first DOWN resistor $Rd_0$ due to variations in the manufacturing process. When the PMOS transistor 1910 and the NMOS transistor 1920 mismatch, the resistance of the first UP resistor $Ru_0$ may be different from that of the first DOWN resistor $Rd_0$. Such a difference in the resistance between the first UP resistor $Ru_0$ and the first DOWN resistor $Ru_0$ degrades signal integrity.

When the resistance of the first UP resistor $Ru_0$ is measured in the test mode, the NMOS transistors 1920, 1940, and 1960 are turned off. When the first DOWN resistor $Rd_0$ is measured in the test mode, the PMOS transistors 1910, 1930, and 1950 are turned off.

The measured resistance of the first UP resistance $Ru_0$ is compared with the predetermined target value of the terminal resistor Rtem_UP, and the fuse 2020 of FIGS. 20 and 21 are appropriately cut. The logic state of the output signals $F_1$ and $F_2$ is dependent upon whether the fuse 2020 is cut or not.

The initial state of signals input to the MOS transistors 1930, 1940, 1950, and 1960 is as follows. The gate of each of the MOS transistors 1930 and 1960 receives the output signal $F_1$ of the control signal generating circuit 2000 of FIG. 20, and the gate of each of the MOS transistors 1940 and 1950 receives the output signal $F_2$ of the control signal generating circuit 2000' of FIG. 21.

In the initial state where the fuse 2020 is not cut, the MOS transistors 1930 and 1940 are turned on, and the MOS transistors 1950 and 1960 are turned off.

When the measured resistance of the first UP resistor $Ru_0$ is greater than the predetermined target value of the termination resistor Rterm_UP, and the fuse 2020 of the control signal generating circuit 2000' connected to the gate of the PMOS transistor 1950 is cut, the control signal $Su_2$ is disabled (for example, in a logic low). Accordingly, the third UP resistor $Ru_2$ is connected in parallel to the first UP resistor $Ru_0$ and the second UP resistor $Ru_1$, and the resistance of the termination resistor Rterm_UP drops close to the predetermined target value.

In contrast, when the measured resistance of the first UP resistor $Ru_0$ is smaller than the predetermined target value of the termination resistor Rterm_UP, and the fuse 2020 of the control signal generating circuit 2000 connected to the gate of the PMOS transistor 1930 is cut, the control signal $Su_1$ is enabled, and the second UP resistor $Ru_1$ is disconnected from the first UP resistor $Ru_0$. Accordingly, the resistance of the termination resistor Rterm_UP increases close to the predetermined target value.

When the measured resistance of the first DOWN resistor $Rd_0$ is greater than the predetermined target value of the termination resistor Rterm_DOWN, and the fuse 2020 of the control signal generating circuit 2000 connected to the gate of the NMOS transistor 1960 is cut, the control signal $Sd_2$ is enabled. Accordingly, the third DOWN resistor $Rd_2$ is connected in parallel to the first DOWN resistor $Ru_0$ and the second DOWN resistor $Rd_1$, and the resistance of the termination resistor Rterm_DN drops close to the predetermined target value.

In contrast, when the measured resistance of the first DOWN resistor $Rd_0$ is smaller than the predetermined target value of the termination resistor Rterm_DOWN, and the fuse 2020 of the control signal generating circuit 2000' connected to the gate of the NMOS transistor 1940 is cut, the control signal $Sd_1$ is disabled, and the second DOWN resistor $Rd_1$ is disconnected from the first DOWN resistor $Rd_0$. Accordingly, the resistance of the termination resistor Rterm_DB increases close to the predetermined target value.

Referring to FIG. 19, although the termination resistors Rterm_UP and Rterm_DN are illustrated as including two resistors $Ru_1$ and $Ru_2$, and $Rd_1$ and $Rd_2$, respectively, to tune the resistance thereof, this embodiment is for illustrative purposes Alternatively, each of the termination resistors Rterm_UP and Rterm_DN may include a plurality of resistors to precisely tune the resistance thereof.

Whether or not to cut the fuse 2020 can be determined in the test mode using a predetermined look-up table.

According to the present invention, the control signals UP, $Su_1$, $Su_2$, DOWN, $Sd_1$, and $Sd_2$ can be generated using a mode register set (MRS). According to the present invention, the resistance of each of the termination resistors Rterm_UP and Rterm_DN can be tuned to a predetermined target value in a chip-test process or after chip packaging.

According to the present invention, the resistance of each of the termination resistors Rterm_UP and Rterm_DN can be effectively tuned, thereby increasing signal integrity of the memory system.

As described above, in the devices and methods for controlling active termination resistors according to the present invention, the on/off of the termination resistors can be controlled irrespective of an operational mode of a delay locked loop (DLL) or phase locked loop (PLL), thereby minimizing data bubbles.

The devices for controlling active termination resistors according to the present invention advantageously increase a data rate of a memory system having a stub bus configuration. The resistance of each of the termination resistors Rterm_UP and Rterm_DN can be effectively tuned, thereby improving signal integrity of the memory system.

**Claims**

1. A memory system (400) comprising a memory circuit (460) in which an active termination circuit (431) is mounted, the active termination circuit comprising:

   a termination resistor which provides a termination resistance for the memory circuit; and
   a control circuit which receives an active termination control signal, and which selectively switches on and off the termination resistor in response to the active termination control signal;

   **characterized in that**
   said control circuit includes a synchronous input buffer (602) and an asynchronous input buffer (603) which each receive the active termination control signal, and a switching circuit (604) which selectively outputs an output of said synchronous input buffer (602) or an output of said asynchronous input buffer (603) according to an operational mode of the memory circuit, and wherein an output of said switching circuit (604) controls an on/off state of said termination resistor.

2. The memory system of claim 1, wherein the operational mode is determined based on an operational mode signal which is supplied externally of the memory circuit.

3. The memory system of claim 1, wherein the switching circuit selects the output of the synchronous input buffer when the memory circuit is in an active operational mode, and selects the output of the asynchronous input buffer when the memory circuit is in a standby or power-down operational mode.

4. The memory system of claim 1, wherein the memory circuit is a DRAM of a single in-line memory module.

5. The memory system of claim 1, wherein the memory circuit is a DRAM of a dual in-line memory module.

6. The memory system of claim 1, wherein the active termination circuit further comprises:-

a mode register which stores data indicative of an operational mode of the memory circuit, and
the control circuit receives an output of the mode register
and the switching circuit selectively outputs an output of said synchronous input buffer or an output of said asynchronous input buffer according to the output of said mode register.

7. The memory system of claim 6, wherein the switching circuit selects the output of the synchronous input buffer when the output of the mode register indicates that the memory circuit is in an active operational mode, and selects the output of the asynchronous input buffer when the output of the mode register indicates that the memory circuit is in a standby or power-down operational mode.

8. The memory system of claim 6, wherein the memory circuit is a DRAM of a single in-line memory module.

9. The memory system of claim 6, wherein the memory circuit is a DRAM of a dual in-line memory module.

10. The memory system of claim 1, wherein the memory circuit is one of a plurality of memory circuits, the memory system further comprising:

a bus line;
the plurality of memory circuits coupled to said bus line;
a chip set, coupled to said bus line, which supplies a plurality of active termination control signals to said memory circuits;

wherein each of the plurality of memory circuits includes a termination resistor and a control circuit, and wherein said control circuit receives the active termination control signal supplied to the memory circuit thereof and selectively switches on and off the termination resistor in response to the active termination control signal;
wherein said control circuit includes a synchronous input buffer and an asynchronous input buffer which each receive the active termination control signal, and a switching circuit which selects one of an output of said synchronous input buffer or an output of said asynchronous input buffer according to an operational mode of the memory circuit containing said synchronous input buffer and said asynchronous input buffer, and wherein an output of said switching circuit controls an on and off state of said termination resistor.

11. The memory system of claim 10, wherein the switching circuit selects the output of the synchronous input buffer when the memory circuit is in an active operational mode, and selects the output of the asynchronous input buffer when the memory circuit is in a standby or power-down operational mode.

12. The memory system of claim 10, further comprising a plurality of memory modules each having at least one of the plurality of memory circuits mounted thereto, wherein the plurality of active termination control signals are supplied to the memory circuits of the plurality of memory modules, respectively, such that the memory circuits of each memory module receive a same one of the plurality of active termination control signals.

13. The memory system of claim 11, further comprising a plurality of memory modules each having at least one of the plurality of memory circuits mounted thereto, wherein the plurality of active termination control signals are individually supplied to the memory circuits of the plurality of memory modules, respectively, such that the memory circuits of each memory module receive a different one of the plurality of active termination control signals.

14. The memory system of claim 11, wherein the plurality of memory circuits are DRAM circuits mounted in dual in-line memory modules.

15. The memory system of claim 10,
wherein each of the plurality of memory circuits includes a mode register which stores data indicative of an operational mode of the memory circuit, and
for each control circuit the switching circuit selects one of an output of said synchronous input buffer or an output of said asynchronous input buffer according to the data of the mode register.

16. The memory system of claim 15, further comprising a plurality of memory modules each having at least one of the plurality of memory circuits mounted thereto, wherein the plurality of active termination control signals are supplied to the memory circuits of the plurality of memory modules, respectively, such that the memory circuits of each memory module receives a same one of the plurality of active termination control signals.

17. The memory system of claim 15, wherein said switching circuit selects the output of said synchronous input buffer when the plurality of memory circuits mounted on at least one side of a corresponding memory module are in an active operational mode, and selects the output of said asynchronous input buffer when all memory circuits of the corresponding memory module are in a standby or power-down operational mode.

18. The memory system of claim 15, wherein the plurality of memory circuits are DRAM circuits mounted in dual in-line memory modules.

19. A method for controlling an operation of a memory system (400):

applying an input signal to a synchronous input buffer (602) and to an asynchronous input buffer (603) of a memory circuit (460);
selectively outputting an output of the synchronous input buffer (602) or an output of the asynchronous input buffer (603) according to an operational mode of the memory circuit; and
enabling and disabling a termination resistance of the memory circuit according to the selected output of the synchronous input buffer or the asynchronous input buffer.

20. The method of claim 19, further comprising receiving an operational mode signal which is supplied externally of the memory circuit, wherein a value of the operational mode signal controls the selective outputting of the output of the synchronous input buffer or the output of the asynchronous input buffer.

21. The method of claim 19, further comprising receiving a value stored in a mode register of the memory circuit, wherein the value of the mode register controls the selective outputting of the output of the synchronous input buffer or the output of the asynchronous input buffer.

22. The method of claim 19 further comprising:

supplying an active termination control signal to both the synchronous input buffer and the asynchronous input buffer of the memory circuit;
selecting an output of the synchronous input buffer when the memory circuit is in an active operational mode, and selecting an output of the asynchronous input buffer when the memory circuit is in a standby or power-down operational mode; and
setting an on/off state of a termination resistor according to the selected one of the output of the synchronous input buffer or the output of the asynchronous input buffer, thereby controlling the on/off state of the termination resistor.

23. The method of claim 19, the memory system having a plurality of memory modules connected to a data bus, each of the memory modules for mounting at least one of a plurality of memory circuits thereto, the plurality of memory circuits having a plurality of termination resistors, said method further comprising:

supplying an active termination control signal to both a synchronous input buffer and an asynchronous input buffer of each of the memory circuits of each of the memory modules;
selecting, in each memory circuit, an output of the synchronous input buffer when the memory circuit is in an active operational mode, and selecting an output of the asynchronous input buffer when the memory circuit is in a standby or power-down operational mode; and
setting, in each memory circuit, an on/off state of the termination resistor according to the selected one of the output of the synchronous input buffer or the output of the asynchronous input buffer, thereby controlling the plurality of termination resistors.

24. The method of claim 19, the memory system having at least a first memory module and a second memory module connected to a data bus, each of the memory modules for mounting at least one of the plurality of memory circuits thereto, the plurality of memory circuits having a plurality of termination resistors, said method further comprising:

transmitting, in response to a read/write instruction of the first memory module, an active termination control signal to each of the memory circuits of the second memory module;

supplying the active termination control signal to both a synchronous input buffer and an asynchronous input buffer of each of the memory circuits of the second memory module;

selecting, in each of the memory circuits of the second memory module, an output of the synchronous input buffer when the second memory module is in an active operational mode, and selecting an output of the asynchronous input buffer when the second memory module is in a standby or power-down operational mode; and

setting, in each of the memory circuits of the second memory module, an on/off state of the termination resistor according to the selected one of the output of the synchronous input buffer or the output of the asynchronous input buffer, thereby controlling the plurality of termination resistors.

**Patentansprüche**

1. Speichersystem (400), umfassend eine Speicherschaltung (460), in der eine aktive Abschlussschaltung (431) angebracht ist, wobei die aktive Abschlussschaltung umfasst:

einen Abschlusswiderstand, der einen Abschlusswiderstand für die Speicherschaltung bereitstellt; und
eine Steuerschaltung, die ein Steuersignal für einen aktiven Abschluss empfängt, und die selektiv den Abschlusswiderstand im Ansprechen auf das Steuersignal für einen aktiven Abschluss selektiv ein- und ausschaltet;

**dadurch gekennzeichnet, dass**
die Steuerschaltung einen synchronen Eingangspuffer (602) und einen asynchronen Eingangspuffer (603), die jeweils das Steuersignal für einen aktiven Abschluss empfangen, und eine Umschaltschaltung (604), die selektiv einen Ausgang des synchronen Eingangspuffers (602) oder einen Ausgang des asynchronen Eingangspuffers (603) gemäß eines Betriebsmodus der Speicherschaltung ausgibt, einschließt, und wobei ein Ausgang der Umschaltschaltung (604) einen Ein-/Aus-Zustand des Abschlusswiderstands steuert.

2. Speichersystem nach Anspruch 1, wobei der Betriebsmodus auf Grundlage eines Betriebsmodussignals bestimmt wird, welches extern von der Speicherschaltung zugeführt wird.

3. Speichersystem nach Anspruch 1, wobei die Umschaltschaltung den Ausgang des synchronen Eingangspuffers wählt, wenn die Speicherschaltung in einem aktiven Betriebsmodus ist, und den Ausgang des asynchronen Eingangspuffers wählt, wenn die Speicherschaltung in einem Standby-Betriebsmodus oder einem Abschalt-Betriebsmodus ist.

4. Speichersystem nach Anspruch 1, wobei die Speicherschaltung ein DRAM eines einzelnen In-Line Speichermoduls ist.

5. Speichersystem nach Anspruch 1, wobei die Speicherschaltung ein DRAM eines dual In-Line Speichermoduls ist.

6. Speichersystem nach Anspruch 1, wobei die aktive Abschlussschaltung ferner umfasst:

ein Modusregister, welches Daten speichert, die einen Betriebsmodus der Speicherschaltung anzeigen; und

wobei die Steuerschaltung einen Ausgang des Modusregisters empfängt,
und die Umschaltung selektiv einen Ausgang des synchronen Eingangspuffers oder einen Ausgang des asynchronen Eingangspuffers gemäß des Ausgangs des Modusregisters selektiv ausgibt.

7. Speichersystem nach Anspruch 6, wobei die Umschaltschaltung den Ausgang des synchronen Eingangspuffers wählt, wenn der Ausgang des Modusregisters anzeigt, dass die Speicherschaltung in einem aktiven Betriebsmodus ist, und den Ausgang des asynchronen Eingangspuffers wählt, wenn der Ausgang des Modusregisters anzeigt, dass die Speicherschaltung in einem Standby-Betriebsmodus oder einem Abschalt-Betriebsmodus ist.

8. Speichersystem nach Anspruch 6, wobei die Speicherschaltung ein DRAM eines einzelnen In-Line Speichermoduls ist.

9. Speichersystem nach Anspruch 6, wobei die Speicherschaltung ein DRAM eines dual In-Line Speichermoduls ist.

10. Speichersystem nach Anspruch 1, wobei die Speicherschaltung eine einer Vielzahl von Speicherschaltungen ist, wobei das Speichersystem ferner umfasst:

eine Busleitung;

wobei die Vielzahl von Speicherschaltungen mit der Busleitung gekoppelt sind;
einen Chipsatz, der mit der Busleitung gekoppelt ist und der eine Vielzahl von Steuersignalen für einen aktiven Abschluss an die Speicherschaltungen führt;
wobei jede der Vielzahl von Speicherschaltungen einen Abschlusswiderstand und eine Steuerschaltung umfasst, und wobei die Steuerschaltung das Steuersignal für den aktiven Abschluss, das an die Speicherschaltung davon geführt wird, empfängt und selektiv den Abschlusswiderstand im Ansprechen auf das Steuersignal für den aktiven Abschluss ein- und ausschaltet;
wobei die Steuerschaltung einen synchronen Eingangspuffer und einen asynchronen Eingangspuffer einschließt, wobei jeder das Steuersignal für einen aktiven Abschluss empfängt, und eine Umschaltung, die selektiv einen Ausgang des synchronen Eingangspuffers oder einen Ausgang des asynchronen Eingangspuffers in Übereinstimmung mit einem Betriebsmodus der Speicherschaltung, die den synchronen Eingangspuffer und den asynchronen Eingangspuffer enthält, wählt, und wobei ein Ausgang der Umschaltschaltung einen Ein- und Aus-Zustand des Abschlusswiderstands steuert.

11. Speichersystem nach Anspruch 10, wobei die Umschaltschaltung den Ausgang des synchronen Eingangspuffers wählt, wenn die Speicherschaltung in einem aktiven Betriebsmodus ist, und den Ausgang des asynchronen Eingangspuffers wählt, wenn die Speicherschaltung in einem Standby-Betriebsmodus oder einem Abschalt-Betriebsmodus ist.

12. Speichersystem nach Anspruch 10, ferner umfassend eine Vielzahl von Speichermodulen, die jeweils wenigstens eine der Vielzahl von darin angebrachten Speicherschaltungen aufweisen, wobei die Vielzahl von Steuersignalen für einen aktiven Abschluss an die Speicherschaltungen der Vielzahl von Speichermodulen jeweils geführt werden, so dass die Speicherschaltungen von jedem Speichermodul ein gleiches der Vielzahl von Steuersignalen für einen aktiven Abschluss empfangen.

13. Speichersystem nach Anspruch 11, ferner umfassend eine Vielzahl von Speichermodulen, die jeweils wenigstens eine der Vielzahl von daran angebrachten Speicherschaltungen aufweisen, wobei die Vielzahl von Steuersignalen für einen aktiven Abschluss individuell an die Speicherschaltungen der Vielzahl von Speichermodulen jeweils geführt werden, so dass die Speicherschaltungen von jedem Speichermodul ein anderes der Vielzahl von Steuersignalen für einen aktiven Abschluss empfangen.

14. Speichersystem nach Anspruch 11, wobei die Vielzahl von Speicherschaltungen DRAM Schaltungen sind, die in dual In-Line Speichermodulen angebracht sind.

15. Speichersystem nach Anspruch 10,
wobei jede der Vielzahl von Speicherschaltungen ein Modusregister einschließt, welches Daten speichert, die einen Betriebsmodus der Speicherschaltungen anzeigen, und
für jede Steuerschaltung die Umschaltschaltung einen Ausgang des synchronen Eingangspuffers oder einen Ausgang des asynchronen Eingangspuffers in Übereinstimmung mit den Daten des Modusregisters wählt.

16. Speichersystem nach Anspruch 15, ferner umfassend eine Vielzahl von Speichermodulen, die jeweils wenigstens eine der Vielzahl von daran angebrachten Speicherschaltungen aufweisen, wobei die Vielzahl von Steuersignalen für einen aktiven Abschluss an die Speicherschaltungen der Vielzahl von Speichermodulen jeweils geführt werden, so dass die Speicherschaltungen jedes Speichermoduls ein gleiches der Vielzahl von Steuersignalen für einen aktiven Abschluss empfangen.

17. Speichersystem nach Anspruch 15, wobei die Umschaltschaltung den Ausgang des synchronen Eingangspuffers wählt, wenn die Vielzahl von auf wenigstens einer Seite eines entsprechenden Speichermoduls angebrachten Speicherschaltungen in einem aktiven Betriebsmodus sind, und den Ausgang des asynchronen Eingangspuffers wählt, wenn alle Speicherschaltungen des entsprechenden Speichermoduls in einem Standby-Betriebsmodus oder einem Abschalt-Betriebsmodus sind.

**18.** Speichersystem nach Anspruch 15, wobei die Vielzahl von Speicherschaltungen DRAM Schaltungen sind, die in dual In-Line Speichermodulen angebracht sind.

**19.** Verfahren zum Steuern eines Betriebs eines Speichersystems (400):

Anlegen eines Eingangssignals an einen synchronen Eingangspuffer (602) und an einen asynchronen Eingangspuffer (603) einer Speicherschaltung (460); selektives Ausgeben eines Ausgangs des synchronen Eingangspuffers (602) oder eines Ausgangs des asynchronen Eingangspuffers (603) gemäß eines Betriebsmodus der Speicherschaltung; und Aktivieren und Deaktivieren eines Abschlusswiderstands der Speicherschaltung gemäß des gewählten Ausgangs des synchronen Eingangspuffers oder des asynchronen Eingangspuffers.

**20.** Verfahren nach Anspruch 19, ferner umfassend ein Empfangen eines Betriebsmodussignals, welches extern von der Speicherschaltung zugeführt wird, wobei ein Wert des Betriebsmodussignals das selektive Ausgeben des Ausgangs des synchronen Eingangspuffers oder des Ausgangs des asynchronen Eingangspuffers steuert.

**21.** Verfahren nach Anspruch 19, ferner umfassend ein Empfangen eines Werts, der in einem Modusregister der Speicherschaltung gespeichert ist, wobei der Wert des Modusregisters das selektive Ausgeben des Ausgangs des synchronen Eingangspuffers oder des Ausgangs des asynchronen Eingangspuffers steuert.

**22.** Verfahren nach Anspruch 19, ferner umfassend die folgenden Schritte:

Zuführen eines Steuersignals für einen aktiven Abschluss an sowohl den synchronen Eingangspuffer als auch den asynchronen Eingangspuffer der Speicherschaltung; Wählen eines Ausgangs des synchronen Eingangspuffers, wenn die Speicherschaltung in einem aktiven Betriebsmodus ist, und Wählen eines Ausgangs des asynchronen Eingangspuffers, wenn die Speicherschaltung in einem Standby-Betriebsmodus oder einem Abschalt-Betriebsmodus ist; und Einstellen eines Ein-/Aus-Zustands eines Abschlusswiderstands gemäß des gewählten Ausgangs des synchronen Eingangspuffers oder des Ausgangs des asynchronen Eingangspuffers, wobei der Ein-/Aus-Zustand des Abschlusswiderstands gesteuert wird.

**23.** Verfahren nach Anspruch 19, wobei das Speichersystem eine Vielzahl von Speichermodulen aufweist, die mit einem Datenbus verbunden sind, wobei jedes der Speichermodule zur Anbringung wenigstens einer einer Vielzahl von Speicherschaltungen daran vorgesehen ist, wobei die Vielzahl von Speicherschaltungen eine Vielzahl von Abschlusswiderständen aufweisen, wobei das Verfahren ferner die folgenden Schritte umfasst:

Anlegen eines Steuersignals für einen aktiven Anschluss an sowohl einen synchronen Eingangspuffer als auch einen asynchronen Eingangspuffer von jeder der Speicherschaltungen von jedem der Speichermodule; Wählen, in jeder Speicherschaltung, eines Ausgangs des synchronen Eingangspuffers, wenn die Speicherschaltung in einem aktiven Betriebsmodus ist, und Wählen eines Ausgangs des asynchronen Eingangspuffers, wenn die Speicherschaltung in einem Standby-Betriebsmodus oder einem Abschalt-Betriebsmodus ist; und Einstellen, in jeder Speicherschaltung, eines Ein-/Aus-Zustands des Abschlusswiderstands gemäß des gewählten Ausgangs des synchronen Eingangspuffers oder des Ausgangs des asynchronen Eingangspuffers, wodurch die Vielzahl von Abschlusswiderständen gesteuert werden.

**24.** Verfahren nach Anspruch 19, wobei das Speichersystem wenigstens ein erstes Speichermodul und ein zweites Speichermodul, verbunden mit einem Datenbus, aufweist, wobei jedes der Speichermodule zum Anbringen wenigstens einer der Vielzahl von Speicherschaltungen daran vorgesehen ist, wobei die Vielzahl von Speicherschaltungen eine Vielzahl von Abschlusswiderständen aufweisen, wobei das Verfahren ferner die folgenden Schritte umfasst:

Übertragen, im Ansprechen auf einen Lese-/Schreib-Befehl des ersten Speichermoduls hin, eines Steuersignals für einen aktiven Abschluss an jede der Speicherschaltungen des zweiten Speichermoduls; Zuführen des Steuersignals für einen aktiven Abschluss an sowohl einen synchronen Eingangspuffer als auch einen asynchronen Eingangspuffer von jeder der Speicherschaltungen des zweiten Speichermoduls; Wählen, in jeder der Speicherschaltungen des zweiten Speichermoduls, eines Ausgangs des synchronen Eingangspuffers, wenn das zweite Speichermodul in einem aktiven Betriebsmodus ist, und Wählen eines Ausgangs des asynchronen Eingangspuffers, wenn das zweite Speichermodul in einem Standby-Betriebsmodus oder einem Abschalt-Betriebsmodus ist; und Setzen, in jeder der Speicherschaltungen des zweiten Speichermoduls, eines Ein-/Aus-Zustands des Abschlusswiderstands gemäß des gewählten Ausgangs des synchronen Eingangspuffers oder des Ausgangs des asynchronen Eingangspuffers, wodurch die Vielzahl von Abschlusswiderständen gesteuert werden.

**Revendications**

1. Système de mémoire (400) comprenant un circuit de mémoire (460) dans lequel un circuit de terminaison actif (431) est monté, le circuit de terminaison actif comprenant:

   une résistance de terminaison qui fournit une résistance de terminaison pour le circuit de mémoire; et
   un circuit de commande qui reçoit un signal de commande de terminaison active, et qui allume/éteint sélectivement la résistance de terminaison en réponse au signal de commande de terminaison active;

   **caractérisé en ce que**
   ledit circuit de commande comprend un tampon d'entrée synchrone (602) et un tampon d'entrée asynchrone (603), qui chacun reçoit le signal de commande de terminaison active, et un circuit de commutation (604) qui fournit sélectivement une sortie dudit tampon d'entrée synchrone (602) ou une sortie dudit tampon d'entrée asynchrone (603) selon un mode opérationnel du circuit de mémoire, et dans lequel une sortie dudit circuit de commutation (604) commande un état en service/hors-service de ladite résistance de terminaison.

2. Système de mémoire selon la revendication 1, dans lequel le mode opérationnel est déterminé sur la base d'un signal de mode opérationnel qui est fourni de façon externe au circuit de mémoire.

3. Système de mémoire selon la revendication 1, dans lequel le circuit de commutation sélectionne la sortie du tampon d'entrée synchrone lorsque le circuit de mémoire est en mode opérationnel actif, et sélectionne la sortie du tampon d'entrée asynchrone lorsque le circuit de mémoire est en mode opérationnel d'attente ou d'alimentation hors-service.

4. Système de mémoire selon la revendication 1, dans lequel le circuit de mémoire est une mémoire DRAM d'un module de mémoire en ligne unique.

5. Système de mémoire selon la revendication 1, dans lequel le circuit de mémoire est une mémoire DRAM d'un module de mémoire en ligne double.

6. Système de mémoire selon la revendication 1, dans lequel le circuit de terminaison actif comprend en outre:

   un registre de mode qui stocke des données indicatrices d'un mode opérationnel du circuit de mémoire, et
   le circuit de commande reçoit une sortie du registre de mode et
   le circuit de commutation fournit sélectivement une sortie dudit tampon d'entrée synchrone ou une sortie dudit tampon d'entrée asynchrone selon la sortie dudit registre de mode.

7. Système de mémoire selon la revendication 6, dans lequel le circuit de commutation sélectionne la sortie du tampon d'entrée synchrone lorsque la sortie du registre de mode indique que le circuit de mémoire est en mode opérationnel actif, et sélectionne la sortie du tampon de mémoire asynchrone lorsque la sortie du registre de mode indique que le circuit de mémoire est en mode opérationnel d'attente ou d'alimentation hors-service.

8. Système de mémoire selon la revendication 6, dans lequel le circuit de mémoire est une mémoire DRAM d'un module de mémoire en ligne unique.

9. Système de mémoire selon la revendication 6, dans lequel le circuit de mémoire est une mémoire DRAM d'un module de mémoire en ligne double.

10. Système de mémoire selon la revendication 1, dans lequel le circuit de mémoire est l'un d'une pluralité de circuits de mémoire, le système de mémoire comprenant en outre:

une ligne de bus;

la pluralité de circuits de mémoire couplés à ladite ligne de bus;

un ensemble de puces, couplé à ladite ligne de bus, qui fournit une pluralité de signaux de commande de terminaison active auxdits circuits de mémoire;

dans lequel chacun de la pluralité de circuits de mémoire comprend une résistante de terminaison et un circuit de commande, et dans lequel ledit circuit de commande reçoit le signal de commande de terminaison active fourni au circuit de mémoire de celui-ci et allume/éteint sélectivement la résistance de terminaison en réponse au signal de commande de terminaison active;

dans lequel ledit circuit de commande comprend un tampon d'entrée synchrone et un tampon d'entrée asynchrone qui chacun reçoivent le signal de commande de terminaison active, et un circuit de commutation qui sélectionne soit une sortie dudit tampon d'entrée synchrone soit une sortie dudit tampon d'entrée asynchrone selon un mode opérationnel du circuit de mémoire contenant ledit tampon d'entrée synchrone et ledit tampon d'entrée asynchrone, et dans lequel une sortie dudit circuit de commutation commande un état en service et hors-service de ladite résistance de terminaison.

11. Système de mémoire selon la revendication 10, dans lequel le circuit de commutation sélectionne la sortie du tampon d'entrée synchrone lorsque le circuit de mémoire est en mode opérationnel actif, et sélectionne la sortie du tampon d'entrée asynchrone lorsque le circuit de mémoire est en mode opérationnel d'attente ou d'alimentation hors-service.

12. Système de mémoire selon la revendication 10, comprenant en outre une pluralité de modules de mémoire ayant chacun au moins un de la pluralité de circuits de mémoire montés sur celui-ci, dans lequel la pluralité de signaux de commande de terminaison active sont fournis aux circuits de mémoire de la pluralité de modules de mémoire, respectivement, de sorte que les circuits de mémoire de chaque module de mémoire reçoivent le même signal de la pluralité de signaux de commande de terminaison active.

13. Système de mémoire selon la revendication 11, comprenant en outre une pluralité de modules de mémoire ayant chacun au moins un de la pluralité de circuits de mémoire montés sur celui-ci, dans lequel la pluralité de circuits de commande de terminaison active est individuellement fournie aux circuits de la pluralité de modules de mémoire, respectivement, de sorte que les circuits de mémoire de chaque module de mémoire reçoivent un signal différent de la pluralité de signaux de commande de terminaison active.

14. Système de mémoire selon la revendication 11, dans lequel la pluralité de circuits de mémoire est faite de circuits DRAM montés dans des modules de mémoire en ligne double.

15. Système de mémoire selon la revendication 10,

dans lequel chacun de la pluralité de circuits de mémoire comprend un registre de mode qui stocke des données indicatrices d'un mode opérationnel du circuit de mémoire, et

pour chaque circuit de commande, le circuit de commutation sélectionne soit une sortie dudit tampon d'entrée synchrone soit une sortie dudit tampon d'entrée asynchrone selon les données du registre de mode.

16. Système de mémoire selon la revendication 15, comprenant en outre une pluralité de modules de mémoire ayant chacun au moins un de la pluralité de circuits de mémoire montée sur celui-ci, dans lequel la pluralité de signaux de commande de terminaison active est fournie aux circuits de mémoire de la pluralité de modules de mémoire, respectivement, de sorte que les circuits de mémoire de chaque module de mémoire reçoivent le même signal de la pluralité de signaux de commande de terminaison active.

17. Système de mémoire selon la revendication 15, dans lequel ledit circuit de commutation sélectionne la sortie dudit tampon d'entrée synchrone lorsque la pluralité de circuits de mémoire montée sur au moins un côté d'un module de mémoire correspondant est en mode opérationnel actif, et sélectionne la sortie dudit tampon d'entrée asynchrone lorsque tous les circuits de mémoire du module de mémoire correspondant sont dans un mode opérationnel d'attente ou d'alimentation hors-service.

18. Système de mémoire selon la revendication 15, dans lequel la pluralité de circuits de mémoire est faite de circuits DRAM montés dans des modules de mémoire en ligne double.

19. Procédé pour commander un fonctionnement d'un système de mémoire (400):

appliquant un signal d'entrée à un tampon d'entrée synchrone (602) et à un tampon d'entrée asynchrone (603) d'un circuit de mémoire (460);

fournissant sélectivement une sortie du tampon d'entrée synchrone (602) ou une sortie du tampon d'entrée asynchrone (603) selon un mode opérationnel du circuit de mémoire; et

activant et désactivant une résistance de terminaison du circuit de mémoire selon la sortie sélectionnée du tampon d'entrée synchrone ou du tampon d'entrée asynchrone.

20. Procédé selon la revendication 19, comprenant en outre la réception d'un signal de mode opérationnel qui est fourni à l'extérieur du circuit de mémoire, dans lequel une valeur du signal de mode opérationnel commande la fourniture sélective de la sortie du tampon d'entrée synchrone ou de la sortie du tampon d'entrée asynchrone.

21. Procédé selon la revendication 19, comprenant en outre la réception d'une valeur stockée dans un registre de mode du circuit de mémoire, dans lequel la valeur du registre de mode commande la fourniture sélective de la sortie du tampon d'entrée synchrone ou de la sortie du tampon d'entrée asynchrone.

22. Procédé selon la revendication 19, comprenant en outre les étapes de:

fourniture d'un signal de commande de terminaison active à la fois au tampon d'entrée synchrone et au tampon d'entrée asynchrone du circuit de mémoire;

sélection d'une sortie du tampon d'entrée synchrone lorsque le circuit de mémoire est en mode opérationnel actif, et sélection d'une sortie du tampon d'entrée asynchrone lorsque le circuit de mémoire est en mode opérationnel d'attente ou d'alimentation hors-service; et

réglage d'un état de mise en service/hors- service d'une résistance de terminaison selon celle sélectionnée de la sortie du tampon d'entrée synchrone ou de la sortie du tampon d'entrée asynchrone, commandant ainsi l'état en service/hors-service de la résistance de terminaison.

23. Procédé selon la revendication 19, le système de mémoire ayant une pluralité de modules de mémoire raccordée au bus de données, chacun des modules de mémoire destiné à monter au moins un de la pluralité de circuits de mémoire sur celui-ci, la pluralité de circuits de mémoire ayant une pluralité de résistances de terminaison, ledit procédé comprenant en outre les étapes de:

fourniture d'un signal de commande de terminaison active à la fois au tampon d'entrée synchrone et au tampon d'entrée asynchrone de chacun des circuits de mémoire de chacun des modules de mémoire;

sélection dans chaque circuit de mémoire, d'une sortie du tampon d'entrée synchrone lorsque le circuit de mémoire est dans un mode opérationnel actif, et sélection d'une sortie du tampon d'entrée asynchrone lorsque le circuit de mémoire est en mode opérationnel d'attente ou d'alimentation hors-service; et

réglage dans chaque circuit de mémoire, d'un état en service/hors-service de la résistance de terminaison selon celle sélectionnée de la sortie du tampon d'entrée synchrone ou de la sortie du tampon d'entrée asynchrone, commandant ainsi la pluralité de résistances de terminaison.

24. Procédé selon la revendication 19, le système de mémoire ayant au moins un premier module de mémoire et un second module de mémoire raccordés au bus de données, chacun des modules de mémoire destiné à monter au moins un de la pluralité de circuits de mémoire sur celui-ci, la pluralité de circuits de mémoire ayant une pluralité de résistances de terminaison, ledit procédé comprenant en outre les étapes de:

transmission, en réponse à une instruction de lecture/écriture du premier module de mémoire, d'un signal de commande de terminaison active pour chacun des circuits de mémoire du second module de mémoire;

fourniture du signal de commande de terminaison active à la fois au tampon d'entrée synchrone et au tampon d'entrée asynchrone de chacun des circuits de mémoire du second module de mémoire;

sélection dans chacun des circuits de mémoire du second module de mémoire, d'une sortie du tampon d'entrée synchrone lorsque le second module de mémoire est en mode opérationnel actif, et sélection d'une sortie du tampon d'entrée asynchrone lorsque le second module de mémoire est en mode opérationnel d'attente ou d'alimentation hors-service; et

réglage dans chacun des circuits de mémoire du second module de mémoire, d'un état en service/hors-service de la résistance de terminaison selon celle sélectionnée de la sortie du tampon d'entrée synchrone ou de la sortie du tampon d'entrée asynchrone, commandant ainsi la pluralité de résistances de terminaison.

# FIG. 1 (PRIOR ART)

# FIG. 2 (PRIOR ART)

EP 1 306 849 B1

# FIG. 3

VDDQ

ON/OFF_1    ON/OFF_2

Rterm    Rterm

Rterm    Rterm

VDDQ

# FIG. 4

400

410    411    440    450

ATC_0    470    480    490
ATC_1

ATC_CS    460    432    401

ATC_CHIP_SET    431

430    ATC_0    ATC_1

402

420

## FIG. 5A

DiMM0     DiMM1
RANK0   RANK1    RANK1

510      520      RANK0

## FIG. 5B

| DLL OR PLL STATUS | | CONTROL MODE OF ACTIVE TERMINATOR | |
|---|---|---|---|
| DiMM0 | DiMM1 | DiMM0 | DiMM1 |
| active | active | Sync cntr | Sync cntr |
| active | Pdn/stby | Off | Async cntr |
| Pdn/stby | active | Async cntr | Off |
| Pdn/stby | Pdn/stby | Off | Off |

# FIG. 5C

# FIG. 5D

| DLL OR PLL STATUS | | CONTROL MODE OF ACTIVE TERMINATOR | |
|---|---|---|---|
| DiMM0 | DiMM1 | DiMM0 | DiMM1 |
| active | — | Sync cntr | — |
| Pdn/stby | — | Off | — |
| — | active | — | Sync cntr |
| — | Pdn/stby | — | Off |

# FIG. 6

## FIG. 7A

## FIG. 7B

# FIG. 8

# FIG. 9A

# FIG. 9B

EP 1 306 849 B1

FIG. 9C

CLK
CMD — WR
ATC1
DQ — Ri1 — Di — Ri2
AT_DiMM1

0 1 2 3 4 5 6 7 8 9 10 11 12 13 14 15 16 17 18 19 20 21 22 23 24 25 26 27

# FIG. 10A

EP 1 306 849 B1

# FIG. 10B

FIG. 10C

EP 1 306 849 B1

# FIG. 11

## FIG. 12A

| DLL OR PLL STATUS | | | | CONTROL MODE OF ACTIVE TERMINATOR | | | |
|---|---|---|---|---|---|---|---|
| RO | R1 | R2 | R3 | RO | R1 | R2 | R3 |
| active | active | active | active | Sync cntr | | Sync cntr | |
| active | active | active | Pdn/stby | Sync cntr | | Sync cntr | Off (flag) |
| active | active | Pdn/stby | active | Sync cntr | | Off (flag) | Sync cntr |
| active | active | Pdn/stby | Pdn/stby | Off (ATC or flag) | | Async cntr | |
| active | Pdn/stby | active | active | Sync cntr | Off (flag) | Sync cntr | |
| active | Pdn/stby | active | Pdn/stby | Sync cntr | Off (flag) | Sync cntr | Off (flag) |
| active | Pdn/stby | Pdn/stby | active | Sync cntr | Off (flag) | Off (flag) | Sync cntr |
| active | Pdn/stby | Pdn/stby | Pdn/stby | Off (ATC or flag) | | Async cntr | |
| Pdn/stby | active | active | active | Off (flag) | Sync cntr | Sync cntr | |
| Pdn/stby | active | active | Pdn/stby | Off (flag) | Sync cntr | Sync cntr | Off (flag) |
| Pdn/stby | active | Pdn/stby | active | Off (flag) | Sync cntr | Off (flag) | Sync cntr |
| Pdn/stby | active | Pdn/stby | Pdn/stby | Off (ATC or flag) | | Async cntr | |
| Pdn/stby | Pdn/stby | active | active | Async cntr | | Off (ATC or flag) | |
| Pdn/stby | Pdn/stby | active | Pdn/stby | Async cntr | | Off (ATC or flag) | |
| Pdn/stby | Pdn/stby | Pdn/stby | active | Async cntr | | Off (ATC or flag) | |
| Pdn/stby | Pdn/stby | Pdn/stby | Pdn/stby | Off (ATC or flag) | | Off (ATC or flag) | |

EP 1 306 849 B1

# FIG. 12B

| DLL OR PLL STATUS | | | CONTROL MODE OF ACTIVE TERMINATOR | | |
|---|---|---|---|---|---|
| RO | R1 | R2 | RO | R1 | R2 |
| active | active | active | Sync cntr | | Sync cntr |
| active | active | Pdn/stby | Off (ATC or flag) | | Async cntr |
| active | Pdn/stby | active | Sync cntr | Off (flag) | Sync cntr |
| active | Pdn/stby | Pdn/stby | Off (ATC or flag) | | Async cntr |
| Pdn/stby | active | active | Off (flag) | Sync cntr | Sync cntr |
| Pdn/stby | active | Pdn/stby | Off (ATC or flag) | | Async cntr |
| Pdn/stby | Pdn/stby | active | Async cntr | | Off (ATC or flag) |
| Pdn/stby | Pdn/stby | Pdn/stby | Off (ATC or flag) | | Off (ATC or flag) |

EP 1 306 849 B1

# FIG. 12C

| DLL OR PLL STATUS | | CONTROL MODE OF ACTIVE TERMINATOR | |
|---|---|---|---|
| RO | R1 | RO | R1 |
| active | active | Sync cntr | Sync cntr |
| active | Pdn/stby | Off | Async cntr |
| Pdn/stby | active | Async cntr | Off |
| Pdn/stby | Pdn/stby | Off | Off |

# FIG. 12D

| DLL OR PLL STATUS | | CONTROL MODE OF ACTIVE TERMINATOR | |
|---|---|---|---|
| RO | R1 | RO | R1 |
| active | active | Sync cntr | |
| active | Pdn/stby | Sync cntr | Off |
| Pdn/stby | active | Off | Sync cntr |
| Pdn/stby | Pdn/stby | Off | Off |

## FIG. 12E

| DLL OR PLL STATUS | | | | CONTROL MODE OF ACTIVE TERMINATOR | | | |
|---|---|---|---|---|---|---|---|
| R0 | R1 | R2 | R3 | R0 | R1 | R2 | R3 |
| active | active | active | active | Sync cntr | | Sync cntr | |
| active | active | active | Pdn/stby | Sync cntr | | Sync cntr | Off |
| active | active | Pdn/stby | active | Sync cntr | | Off | Sync cntr |
| active | active | Pdn/stby | Pdn/stby | Off | | Async cntr | |
| active | Pdn/stby | active | active | Sync cntr | Off | Sync cntr | |
| active | Pdn/stby | active | Pdn/stby | Sync cntr | Off | Sync cntr | Off |
| active | Pdn/stby | Pdn/stby | active | Sync cntr | Off | Off | Sync cntr |
| active | Pdn/stby | Pdn/stby | Pdn/stby | Off | | Async cntr | |
| Pdn/stby | active | active | active | Off | Sync cntr | Sync cntr | |
| Pdn/stby | active | active | Pdn/stby | Off | Sync cntr | Sync cntr | Off |
| Pdn/stby | active | Pdn/stby | active | Off | Sync cntr | Off | Sync cntr |
| Pdn/stby | active | Pdn/stby | Pdn/stby | Off | | Async cntr | |
| Pdn/stby | Pdn/stby | active | active | Async cntr | | Off | |
| Pdn/stby | Pdn/stby | active | Pdn/stby | Async cntr | | Off | |
| Pdn/stby | Pdn/stby | Pdn/stby | active | Async cntr | | Off | |
| Pdn/stby | Pdn/stby | Pdn/stby | Pdn/stby | Off | | Off | |

# FIG. 13

EP 1 306 849 B1

# FIG. 14

# FIG. 15

# FIG. 16

# FIG. 17

DiMM0

$R_0$

DiMM1

1110

1120

# FIG. 18

1800

1811

ATC_0_R1
ATC_0_R0
ATC_0_R3
ATC_0_R2

ATC_CS

430

1810

1840

RANK1
RANK0

1860    1870

ATC_0_R1

ATC_0_R0

1850

RANK3
RANK2

1880    1890

ATC_1_R3

ATC_1_R2

1801

1802

1820

# FIG. 19

1900

# FIG. 20

2000

# FIG. 21

VDDQ

2010

2000'

VCCHB

V

TIME

2050

2060

F2

(F) 2020

2030 2040

VSSQ

**EP 1 306 849 B1**

## REFERENCES CITED IN THE DESCRIPTION

**Patent documents cited in the description**

- US 4748426 A
- US 5878250 A
- EP 0818734 A